(19) **Europäisches Patentamt European Patent Office Office européen des brevets**

(11) **EP 3 618 312 B1**

(12) **EUROPEAN PATENT SPECIFICATION**

(45) Date of publication and mention
of the grant of the patent:
**17.02.2021  Bulletin 2021/07**

(21) Application number: **18792059.0**

(22) Date of filing: **12.04.2018**

(51) Int Cl.:
*G10L 19/00* (2013.01)      *H03M 7/32* (2006.01)
*H04B 14/04* (2006.01)      *G10L 19/16* (2013.01)
*G11B 20/08* (2006.01)      *H04M 3/02* (2006.01)

(86) International application number:
**PCT/JP2018/015351**

(87) International publication number:
**WO 2018/198788 (01.11.2018 Gazette 2018/44)**

(54) **SIGNAL PROCESSING DEVICE, SIGNAL PROCESSING METHOD AND PROGRAM**

SIGNALVERARBEITUNGSVORRICHTUNG, SIGNALVERARBEITUNGSVERFAHREN UND
PROGRAMM

DISPOSITIF DE TRAITEMENT DE SIGNAL, PROCÉDÉ DE TRAITEMENT DE SIGNAL ET
PROGRAMME

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority:  **26.04.2017   JP 2017087207**

(43) Date of publication of application:
**04.03.2020   Bulletin 2020/10**

(73) Proprietor: **Sony Corporation
Tokyo 108-0075 (JP)**

(72) Inventor: **FUKUI Takao
Tokyo 108-0075 (JP)**

(74) Representative: **2SPL Patentanwälte PartG mbB
Postfach 15 17 23
80050 München (DE)**

(56) References cited:
**WO-A1-2016/199596      JP-A- H09 282 800
JP-A- 2015 079 218      US-A1- 2006 058 901
US-A1- 2009 287 493      US-A1- 2015 107 442**

**Description**

TECHNICAL FIELD

The present technology relates to a signal processing apparatus, a signal processing method, and a program, and particularly relates to a signal processing apparatus, a signal processing method, and a program that can smoothly switch and reproduce a DSD signal and a PCM signal.

BACKGROUND ART

In recent years, music distribution using high-resolution sound source, which is audio data having sound quality exceeding music CD (CD-DA), has been performed.

In music distribution using a digital signal that is delta-sigma modulated in a 1-bit signal (hereinafter also called direct stream digital (DSD) signal), distribution of not only a DSD signal having a sampling frequency of 64 times sampling frequency 44.1 kHz of CD used for super audio CD (SACD) (64 DSD signal), but also a 128 times DSD signal (128 DSD signal) and a 256 times DSD signal (256 DSD signal) has been performed experimentally.

The DSD signal has a sampling frequency higher than that of a pulse code modulation (PCM) signal. Therefore, the communication capacity in the case of performing streaming distribution becomes larger than the PCM signal. For example, the data capacity of the 64 DSD signal in which one frame is three seconds in a stereo (two channels) signal is about 2.8 Mbit/frame.

Thus, in Patent Document 1, the present applicant has proposed a compression method in which a DSD signal is lossless-compressed and transmitted.

Meanwhile, as handling method corresponding to situations of a communication path, for example, like moving picture experts group - dynamic adaptive streaming over HTTP (MPEG-DASH), there is a technology in which a plurality of encoded data obtained when the same content is expressed at different bit rates is stored in a content server and a client apparatus performs streaming reception of desired encoded data from among the plurality of encoded data depending on the communication capacity of a network.

In Patent Document 2, the present applicant proposes a method in which, for music distribution using a DSD signal, a streaming method like MPEG-DASH is used to dynamically and selectively view a DSD signal having better quality in line with the communication line capacity from among different bit rate signals of the same content, e.g., a 64 DSD signal, a 128 DSD signal, and a 256 DSD signal.

Patent Documents 3 - 5 also relate to the field of handling Direct Stream Digital (DSD) audio data.

CITATION LIST

PATENT DOCUMENT

Patent Document 1: WO 2016/140071 A
Patent Document 2: WO 2016/199596 A
Patent Document 3: US 2009/287493 A1
Patent Document 4: US 2006/058901 A1
Patent Document 5: US 2015/107442 A1

SUMMARY OF THE INVENTION

PROBLEMS TO BE SOLVED BY THE INVENTION

However, the DSD signal has a higher bit rate than the PCM signal even when compressed by the compression method of Patent Document 1 or the like.

For example, even when DSD data having a sampling frequency (2.8 MHz) of 64 times the sampling frequency 44.1 kHz of CD used for super audio CD (SACD) can be compressed to 50% by using a predetermined compression method, a bit rate is 2.8 Mbps in a stereo (two channel) signal.

In contrast, in a case where a PCM signal of CD sound quality is transferred as it is, if there is quantization bit 16-bit audio data having a sampling frequency of 44.1 kHz for two channels, a bit rate is 1.4 Mbps, which is about half of the bit rate of the DSD data whose compression rate is 50% as described above. Moreover, when compression coding, e.g., AAC, is used for the PCM signal, communication can be performed at a much smaller bit rate of about 320 kbps.

Accordingly, it is desirable that a PCM signal can also be selected on the basis of the assumption of a case where the communication line capacity becomes severe with a DSD signal.
The present technology has been made in view of such circumstances to enable reproduction by smoothly switching a DSD signal and a PCM signal.

SOLUTIONS TO PROBLEMS

A signal processing apparatus according to an aspect of the present technology includes: an acquisition unit that acquires a PCM signal and a DSD signal; a PCM upsampling unit that upsamples the PCM signal to a sampling frequency of the DSD signal; a DSD filter that removes a high-frequency component of the DSD signal; a delay amount detection unit that analyzes a correlation between the DSD signal from which a high-frequency component has been removed and the PCM signal after upsampling, and detects a delay amount; and a crossfade unit that adjusts timing of the DSD signal and the PCM signal after upsampling by using the detected delay amount and crossfades the DSD signal and the PCM signal after upsampling.
A signal processing method according to an aspect of the present technology includes steps of, by a signal processing apparatus: acquiring a PCM signal and a DSD signal; upsampling the PCM signal to a sampling frequency of the DSD signal; removing a high-frequency component of the DSD signal; analyzing a correlation between the DSD signal from which a high-frequency component has been removed and the PCM signal after upsampling, and detecting a delay amount; and adjusting timing of the DSD signal and the PCM signal after upsampling by using the detected delay amount, and crossfading the DSD signal and the PCM signal after upsampling.
A program according to an aspect of the present technology for causing a computer to function as: an acquisition unit that acquires a PCM signal and a DSD signal; a PCM upsampling unit that upsamples the PCM signal to a sampling frequency of the DSD signal; a DSD filter that removes a high-frequency component of the DSD signal; a delay amount detection unit that analyzes a correlation between the DSD signal from which a high-frequency component has been removed and the PCM signal after upsampling, and detects a delay amount; and a crossfade unit that adjusts timing of the DSD signal and the PCM signal after upsampling by using the detected delay amount and crossfades the DSD signal and the PCM signal after upsampling.
According to an aspect of the present technology, a PCM signal and a DSD signal are acquired, the PCM signal is upsampled to a sampling frequency of the DSD signal, a high-frequency component of the DSD signal is removed, and a correlation between the DSD signal from which a high-frequency component has been removed and the PCM signal after upsampling is analyzed and a delay amount is detected. Timing of the DSD signal and the PCM signal after upsampling is adjusted by using the detected delay amount, and the DSD signal and the PCM signal after upsampling are crossfaded.
Note that the program can be provided by being transferred via a transfer medium or by being recorded on a recording medium.
Note that the signal processing apparatus according to an aspect of the present technology can be achieved by causing a computer to execute the program.
Furthermore, in order to achieve the signal processing apparatus according to an aspect of the present technology, the program to be executed by the computer can be provided by being transmitted via a transmission medium or by being recorded on a recording medium.
Note that the signal processing apparatus may be an independent apparatus, or may be an internal block constituting a single apparatus.

EFFECTS OF THE INVENTION

According to an aspect of the present technology, a DSD signal and a PCM signal can be smoothly switched and reproduced.
Note that effects described herein are not necessarily limited, but may also be any of those described in the present disclosure.

BRIEF DESCRIPTION OF DRAWINGS

Fig. 1 is a block diagram illustrating a configuration example of an embodiment of a reproduction system to which the present technology has been applied.
Fig. 2 is a block diagram illustrating a detailed configuration example of a reproduction apparatus of Fig. 1.
Fig. 3 is a diagram explaining DSD upsampling processing.

Fig. 4 is a diagram explaining detection of delay amount N3 by a correlation analysis unit.

Fig. 5 is a table explaining signal matching detection processing by a signal matching detection unit.

Fig. 6 is a diagram explaining signal matching detection processing by a signal matching detection unit.

Fig. 7 is a diagram explaining signal matching detection processing by a signal matching detection unit.

Fig. 8 is a diagram explaining signal matching detection processing by a signal matching detection unit.

Fig. 9 is a diagram explaining signal matching detection processing by a signal matching detection unit.

Fig. 10 is a diagram explaining signal matching detection processing by a signal matching detection unit.

Fig. 11 is a diagram explaining signal matching detection processing by a signal matching detection unit.

Fig. 12 is a flowchart explaining DSD data reproduction processing.

Fig. 13 is a flowchart explaining AAC data reproduction processing.

Fig. 14 is a flowchart explaining reproduction switch processing.

Fig. 15 is a block diagram illustrating a detailed configuration example of a reproduction apparatus in a case where a maximum bit rate of DSD data is 5.6 Mbps.

Fig. 16 is a block diagram illustrating a detailed configuration example of a reproduction apparatus in a case where a maximum bit rate of DSD data is 2.8 Mbps.

Fig. 17 is a block diagram illustrating a detailed configuration example of a reproduction apparatus in a case where a plurality of PCM data is switched.

Fig. 18 is a block diagram illustrating a configuration example of an embodiment of a computer to which the present technology has been applied.

MODE FOR CARRYING OUT THE INVENTION

Modes for carrying out the present technology (hereinafter, the embodiments) are described below. Note that description will be presented in the following order.

1. Configuration example of reproduction system
2. Detailed configuration example of reproduction apparatus
3. Processing example of signal matching detection unit
4. DSD data reproduction processing
5. AAC data reproduction processing
6. Reproduction switch processing
7. Detailed configuration example of reproduction apparatus in a case where a maximum bit rate is 5.6 Mbps
8. Detailed configuration example of reproduction apparatus in a case where a maximum bit rate is 2.8 Mbps
9. Detailed configuration example of reproduction apparatus in a case where a plurality of PCM data having different bit rates is switched
10. Example of application to computer

<1. Configuration example of reproduction system>

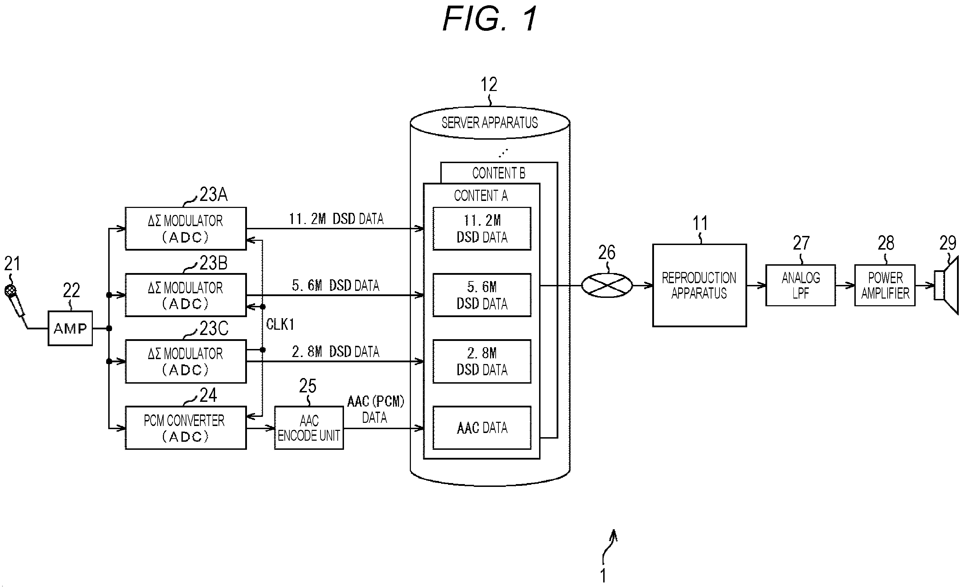

Fig. 1 is a block diagram illustrating a configuration example of an embodiment of a reproduction system to which the present technology has been applied.

The reproduction system 1 of Fig. 1 is a system that at least includes a reproduction apparatus 11 and a server apparatus 12, and the reproduction apparatus 11 acquires and reproduces audio data stored in the server apparatus 12.

The server apparatus 12 stores a plurality of audio data obtained when one sound source (content) collected by a microphone 21 is AD-converted at different sampling frequencies.

Specifically, an audio signal of a predetermined sound source (e.g., content A) collected by the microphone 21 is amplified by an amplifier (AMP) 22, and the resultant audio signal is fed to a plurality of delta-sigma ($\Delta\Sigma$) converters 23 and one PCM converter 24. In the present embodiment, the number of delta-sigma modulators 23 is three, but is not limited to three.

The delta-sigma modulator 23 converts an input analog audio signal to a digital signal (AD conversion) by delta-sigma modulation.

The plurality of delta-sigma modulators 23 has different sampling frequencies in the case of delta-sigma modulation.

For example, a delta-sigma modulator 23A performs delta-sigma modulation on an input analog audio signal at a sampling frequency of 256 times the sampling frequency 44.1 kHz of a compact disc (CD), and causes the server apparatus 12 to store a resulting DSD signal. The DSD signal obtained by delta-sigma modulation at the sampling frequency of 256 times the sampling frequency 44.1 kHz is a bit rate of 11.2 Mbps and is therefore hereinafter also called 11.2M DSD data.

A delta-sigma modulator 23B performs delta-sigma modulation on an input analog audio signal at a sampling frequency of 128 times the sampling frequency 44.1 kHz of CD, and causes the server apparatus 12 to store a resulting DSD signal. The DSD signal obtained by delta-sigma modulation at the sampling frequency of 128 times the sampling frequency 44.1 kHz is a bit rate of 5.6 Mbps and is therefore hereinafter also called 5.6M DSD data.

A delta-sigma modulator 23C performs delta-sigma modulation on an input analog audio signal at a sampling frequency of 64 times the sampling frequency of 44.1 kHz of CD, and causes the server apparatus 12 to store a resulting DSD signal. The DSD signal obtained by delta-sigma modulation at the sampling frequency of 64 times the sampling frequency 44.1 kHz is a bit rate of 2.8 Mbps and is therefore hereinafter also called 2.8M DSD data.

The PCM converter 24 converts an input analog audio signal to a quantization bit 16-bit pulse code modulation (PCM) signal of sampling frequency 44.1 kHz of CD (AD conversion) and feeds the signal to an AAC coding unit 25.

The AAC coding unit 25 compression-codes a PCM signal fed from the PCM converter 24 by an advanced audio coding (AAC) coding method, and causes the server apparatus 12 to store a resulting AAC signal (also called AAC data) .

The delta-sigma modulators 23A to 23C and the PCM converter 24 are synchronized with one another with reference to one clock signal CLK1 during AD conversion and perform AD conversion. For example, the delta-sigma modulator 23C, which is one of the delta-sigma modulators 23A to 23C and the PCM converter 24, feeds a clock signal CLK 1 generated by the delta-sigma modulator 23C to the delta-sigma modulators 23A and 23B, and the PCM converter 24. The delta-sigma modulators 23A to 23C and the PCM converter 24 perform AD conversion on the basis of the clock signal CLK1 generated by the delta-sigma modulator 23C.

The sampling frequencies of the delta-sigma modulators 23A to 23C are a frequency calculated by power of 2 of base frequency $f_b$, which is sampling frequency 44.1 kHz of CD. Note that it is sufficient if the sampling frequencies of the delta-sigma modulators 23A to 23C are in relationship of power of 2, i.e., in relationship of multiplication with powers of 2 or division with powers of 2, and the base frequency $f_b$ is not required to be 44.1 kHz equivalent to the sampling frequency of CD.

The server apparatus 12 stores a plurality of audio data having different sampling frequencies generated from one sound source (content) as described above.

The reproduction apparatus 11, in line with communication capacity of a network 26 for access to the server apparatus 12, selects, acquires, and reproduces any one from the plurality of types of audio data having different bit rates of the same content, i.e., 11.2M DSD data, 5.6M DSD data, 2.8M DSD data, and AAC data.

The reproduction apparatus 11 switches audio data of the same content having different bit rates as necessary even in the middle of one piece of content, but the reproduction apparatus 11 is configured to seamlessly switch audio data having different bit rates without generation of noises during switching.

There is a moving picture experts group - dynamic adaptive streaming over HTTP (MPEG-DASH) as a standard of a method in which a plurality of encoded data obtained when the same content is expressed at different bit rates is stored in the content server, and a client apparatus receives desired encoded data in a streaming manner from the plurality of stored encoded data depending on the communication capacity of the network.

The server apparatus 12 stores the plurality of audio data having different sampling frequencies with respect to one piece of content by a method compliant with the MPEG-DASH standards.

MPEG-DASH acquires and reproduces streaming data in accordance with a metafile called media presentation description (MPD) and an address (URL: uniform resource locator) of chunked media data described in the metafile, such as audios, videos, or captions.

In the present embodiment, as the chunked audio data, for example, audio data in which a sound source of three seconds per frame is a file (segment file) unit is stored in the server apparatus 12.

Note that, in the present embodiment, a description is given on the basis of the assumption that the four types of audio data: 11.2M DSD data, 5.6M DSD data, 2.8M DSD data, and AAC data with respect to one sound source (content) are stored in the server apparatus 12. However, the type of audio data generated with respect to one sound source (content) is not limited to the four types.

Furthermore, the server apparatus 12 stores a plurality of DSD data and AAC data having different sampling frequencies with respect to a plurality of pieces of content, such as content A, content B, and content C.

The reproduction apparatus 11 receives digital audio data transmitted from the server apparatus 12, converts the audio data into an analog signal, and outputs the analog signal to an analog LPF 27.

The analog low pass filter (LPF) 27 performs filtering processing of removing a high frequency component and outputs the signal after the filtering processing to a power amplifier 28.

The power amplifier 28 amplifies the analog audio signal output from the analog LPF 27 and outputs the audio signal to a speaker 29. The speaker 29 outputs the audio signal fed from the power amplifier 28 as sounds.

Analog output units of the analog LPF 27, the power amplifier 28, and the speaker 29 may be incorporated as part of the reproduction apparatus 11.

<2. Detailed configuration example of reproduction apparatus>

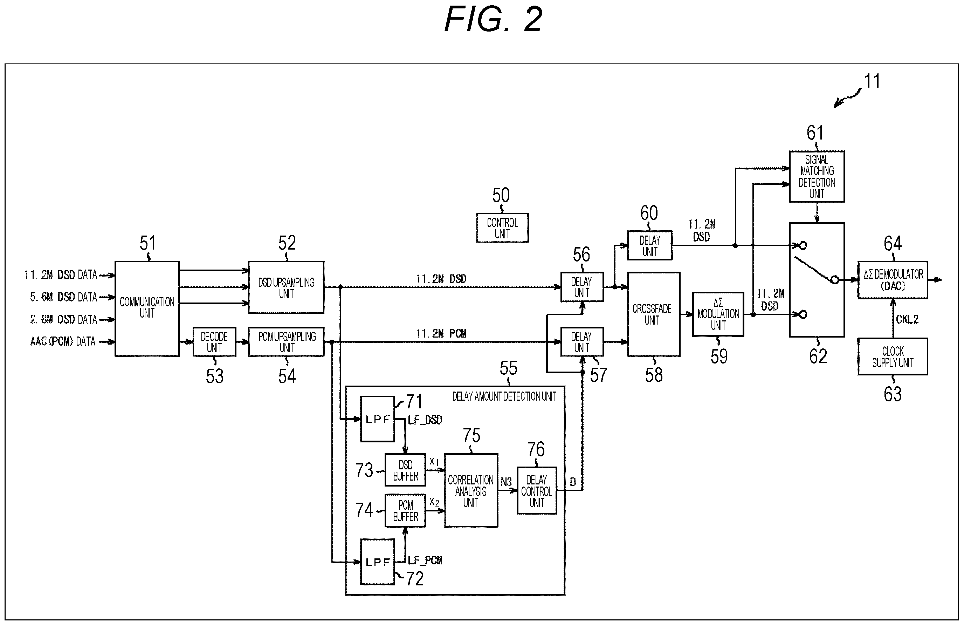

Fig. 2 is a block diagram illustrating a detailed configuration example of the reproduction apparatus 11 of Fig. 1.

The reproduction apparatus 11 includes a control unit 50, a communication unit 51, a DSD upsampling unit 52, a decode unit 53, a PCM upsampling unit 54, and a delay amount detection unit 55.

Furthermore, the reproduction apparatus 11 includes delay units 56 and 57, a crossfade unit 58, delta-sigma ($\Delta\Sigma$) modulation unit 59, a delay unit 60, a signal matching detection unit 61, a switch unit 62, a clock supply unit 63, and a delta-sigma demodulator 64.

The control unit 50 controls the operation of the entire reproduction apparatus 11. For example, the control unit 50, on an operation unit not illustrated, when a user gives an instruction of reproducing predetermined content stored in the server apparatus 12, from among a plurality of types of audio data (DSD data and AAC data) having different bit rates corresponding to the content for which the reproduction instruction has been given, selects any one audio data in line with the communication capacity of the network 26, and gives a request to the server apparatus 12 via the communication unit 51. In a case of switching a plurality of types of audio data having a plurality of different bit rates, the control unit 50 feeds information that specifies audio data to be faded in and audio data to be faded out to the delay units 56 and 57, and the crossfade unit 58. Note that, in Fig. 2, illustration of a control signal from the control unit 50 to each unit is omitted.

In a case where the audio data is acquired in accordance with MPEG-DASH as streaming data of content, the control unit 50 first acquires an MPD file, and, on the basis of the acquired MPD file, causes the communication unit 51 to access a predetermined address of the server apparatus 12 to cause the communication unit 51 to acquire the desired audio data.

The communication unit 51 gives a request to the server apparatus 12 for one or two of the plurality of types of audio data (DSD data and AAC data) having different bit rates corresponding to the content for which a reproduction instruction has been given, on the basis of the instruction of the control unit 50. In a case of switching from first audio data to second audio data, the bit rates of which are different, the communication unit 51 simultaneously acquires the two audio data: the first and second audio data, and, in a case where there is no necessity of switching, acquires one audio data.

The communication unit 51 acquires the digital audio data transmitted from the server apparatus 12 and feeds the acquired audio data to the DSD upsampling unit 52 or the decode unit 53.

More specifically, in a case where 11.2M DSD data, 5.6M DSD data, or 2.8M DSD data is acquired as audio data, the communication unit 51 feeds the acquired DSD data to the DSD upsampling unit 52. Meanwhile, in a case where AAC data is acquired as audio data, the communication unit 51 feeds the acquired AAC data to the decode unit 53.

The DSD upsampling unit 52 upsamples the DSD data having a predetermined bit rate fed from the communication unit 51 to DSD data having a maximum bit rate that can be reproduced by the reproduction apparatus 11, and feeds the DSD data after the upsampling processing to the delay amount detection unit 55 and the delay unit 56.

In the present embodiment, the DSD data that can be acquired from the server apparatus 12 is any of 11.2M DSD data, 5.6M DSD data, and 2.8M DSD data, and the maximum bit rate of the DSD data that can be reproduced by the reproduction apparatus 11 is 11.2 Mbps. Accordingly, the DSD upsampling unit 52 upsamples the acquired DSD data to 11.2M DSD data, and outputs the DSD data to the delay amount detection unit 55 and the delay unit 56.

<DSD upsampling processing>

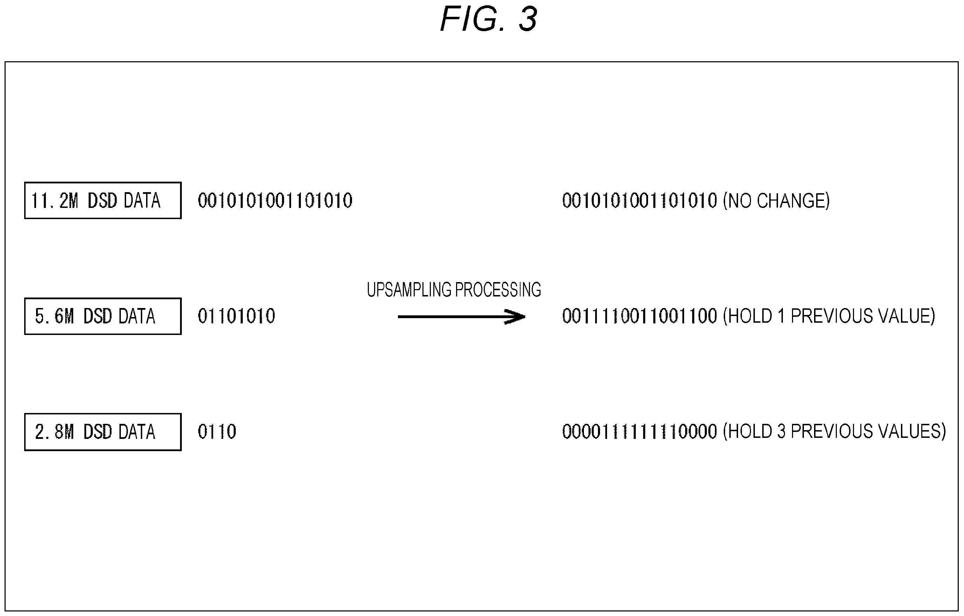

The DSD upsampling processing performed by the DSD upsampling unit 52 is described with reference to Fig. 3.

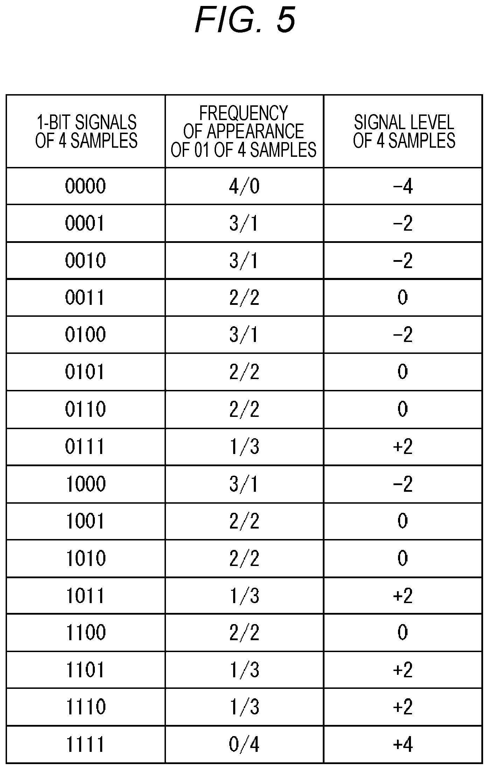

For example, in a case where 11.2M DSD data of a predetermined period stored in the server apparatus 12 is expressed by 16 bits "0010101001101010" as illustrated in Fig. 3, 5.6M DSD data is expressed by 8-bit data, e.g., "01101010", and 2.8M DSD data is expressed by 4-bit data, e.g., "0110". Note that 11.2M DSD data, 5.6M DSD data, and 2.8M DSD data illustrated in Fig. 3 are to describe a difference in bit depth, but are not digitized data from the same audio signal.

In a case where the DSD data fed from the communication unit 51 is DSD data other than DSD data having a maximum bit rate that can be reproduced by the reproduction apparatus 11, the DSD upsampling unit 52 converts the DSD data fed from the communication unit 51 to have a data length of the DSD data having a maximum bit rate.

Specifically, in a case where the DSD data fed from the communication unit 51 is 5.6M DSD data, its data length is 1/2 of that of the DSD data (11.2M DSD data) having a maximum bit rate. Therefore, the DSD upsampling unit 52 outputs each bit value of 5.6M DSD data fed from the communication unit 51 twice.

Furthermore, in a case where the DSD data fed from the communication unit 51 is 2.8M DSD data, its data length is 1/4 of that of the DSD data (11.2M DSD data) having a maximum bit rate. Therefore, the DSD upsampling unit 52 outputs each bit value of 2.8M DSD data fed from the communication unit 51 four times.

As described above, the DSD upsampling unit 52 performs pre-interpolation on the DSD data fed from the communication unit 51 at a rate with respect to the DSD data having a maximum bit rate and outputs it to the delay unit 56. In a case where the DSD data fed from the communication unit 51 is DSD data having a maximum bit rate, the DSD upsampling unit 52 outputs the fed DSD data as it is.

Referring back to Fig. 2, the decode unit 53 decodes the AAC data fed from the communication unit 51 by a decoding method corresponding to the encoding method, and outputs the PCM signal obtained by decoding to the PCM upsampling unit 54.

The PCM upsampling unit 54 upsamples the PCM signal fed from the decode unit 53 to the same frequency as the sampling frequency of the DSD data output from the DSD upsampling unit 52, and outputs the PCM signal to the delay amount detection unit 55 and the delay unit 57.

In the present embodiment, the sampling frequency of the PCM signal stored as AAC data is sampling frequency 44.1 kHz. Accordingly, the PCM upsampling unit 54 upsamples the PCM signal having sampling frequency 44.1 kHz to a PCM signal having sampling frequency 11.2 MHz, and outputs the PCM signal to the delay amount detection unit 55 and the delay unit 57. The PCM signal having sampling frequency 11.2 MHz is also called 11.2M PCM data below.

The delay amount detection unit 55 analyses a correlation between 11.2M DSD data fed from the DSD upsampling unit 52 and 11.2M PCM data fed from the PCM upsampling unit 54, detects delay amount D between the signals, and outputs the delay amount D to the delay units 56 and 57.

The delay amount detection unit 55 includes LPFs 71 and 72, a DSD buffer 73, a PCM buffer 74, a correlation analysis unit 75, and a delay control unit 76.

The LPF 71 removes a high-frequency component of 11.2M DSD data fed from the DSD upsampling unit 52, and outputs 11.2M DSD data after high frequency removable to the DSD buffer 73. The number of taps of the LPF 71 is N1. The 11.2M DSD data after high frequency removal is called LF_DSD data.

The LPF 72 removes a high-frequency component of 11.2M PCM data fed from the PCM upsampling unit 54, and outputs 11.2M PCM data after high frequency removal to the PCM buffer 74. The number of taps of the LPF 72 is N2. The 11.2M PCM data after high frequency removal is called LF_PCM data.

The 11.2M DSD data and the 11.2M PCM data have different high frequency signals, and therefore cannot be simply compared in phase. Therefore, the phases of the 11.2M DSD data and the 11.2M PCM data are compared with regard to a narrowed signal having a predetermined frequency or less using the LPFs 71 and 72. For example, the LPFs 71 and 72 perform filtering processing that performs narrowing to a signal having frequency band of 1/2 or less of sampling frequency 44.1 kHz of the PCM signal.

The DSD buffer 73 buffers the LF_DSD data fed from the LPF 71 for a length of a predetermined period of time and outputs required data to the correlation analysis unit 75. The PCM buffer 74 buffers the LF_PCM data fed from the LPF 72 for a length of a predetermined period of time and outputs required data to the correlation analysis unit 75. The buffering periods of the DSD buffer 73 and the PCM buffer 74 can be set to any time, but are set, for example, to about one second in consideration of process delay, AAC decode delay, or the like.

The correlation analysis unit 75 analyses a correlation between the LF_DSD data stored in the DSD buffer 73 and the LF_PCM data stored in the PCM buffer 74, and detects delay amount N3 of the LF_PCM data and the LF_PCM data.

When the LF_DSD data stored in the DSD buffer 73 is $x_1$ and the LF_PCM data stored in the PCM buffer 74 is $x_2$, the correlation analysis unit 75 executes processing of calculating Formula (1) below to detect the delay amount N3.

[Mathematical 1]

$$N3 = \text{argmax}_\tau \, \phi_{1,2}(\tau), \, \phi_{1,2}(\tau) = \sum_k x_1(k) x_2(k+\tau) \qquad \cdots (1)$$

Formula (1) is a formula that detects deviation amount $\tau$ with which a production of correlation functions $\phi_{1,2}(\tau)$ of the LF_DSD data $x_1$ and the LF_PCM data $x_2$ is maximum.

<Detection of delay amount N3>

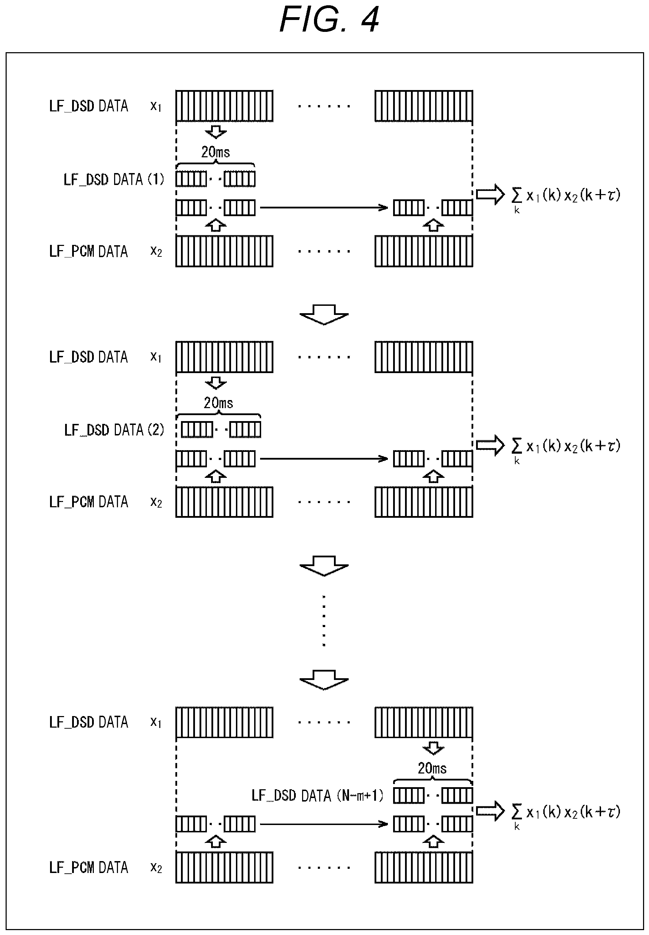

Detection of the delay amount N3 by the correlation analysis unit 75 is described with reference to Fig. 4.

A comparison length at the time of comparison between the LF_DSD data $x_1$ and the LF_PCM data $x_2$ is preliminarily determined to be a predetermined length. For example, the comparison length is 20 msec which is the same as the frame length of AAC.

In Fig. 4, the number of samples of the LF_DSD data $x_1$ and the LF_PCM data $x_2$ stored in each buffer is N, and the number of samples of the comparison length is m.

First of all, the correlation analysis unit 75 extracts LF_DSD data for the comparison length (number of samples m) from a head sample (1) of the LF_DSD data $x_1$, and calculates a product sum ($\sum x_1(k)x_2(k+\tau)$) of the extracted LF_DSD data (1) and LF_PCM data (1) to LF_PCM data (N-m+1). Here, the LF_PCM data (1) to LF_PCM data (N-m+1) are data extracted for the comparison length from the LF_PCM data $x_2$ while the head sample is shifted from sample (1) to sample (N-m+1) sample by sample.

Next, the correlation analysis unit 75 extracts LF_DSD data of the comparison length (number of samples m) from a second sample (2) of the LF_DSD data $x_1$ shifted by one sample from the head sample to be extracted, and calculates a product sum ($\sum x_1(k)x_2(k+\tau)$) of the extracted LF_DSD data (2) and the LF_PCM data (1) to LF_PCM data (N-m+1).

Similarly, while the LF_DSD data $x_1$ is shifted by one sample until the head sample of the extracted LF_DSD data reaches (N-m+1)th sample (N-m+1), a product sum ($\sum x_1(k)x_2(k+\tau)$) of the LF_DSD data of the extracted comparison length and the LF_PCM data (1) to LF_PCM data (N-m+1) is calculated.

In the above calculation, a deviation amount $\tau$ with which product sum ($\sum x_1(k)x_2(k+\tau)$) becomes maximum is the delay amount N3 to be corrected.

Referring back to Fig. 2, the correlation analysis unit 75 feeds the detected delay amount N3 to the delay control unit 76.

The delay control unit 76 calculates Formula (2) below in which a time difference (N1/2 to N2/2) of the filtering processing of the LPF 71 and the LPF 72 is added to the delay amount N3 fed from the correlation analysis unit 75, detects the delay amount D between the signals, and outputs the delay amount D between the signals to the delay units 56 and 57.

[Mathematical 2]

$$D = N3 + \left( \frac{N1}{2} - \frac{N2}{2} \right) \qquad \cdot \cdot \cdot (2)$$

The delay units 56 and 57 adjust the timing of the 11.2M DSD data and the 11.2M PCM data in order to perform crossfade processing of the 11.2M DSD data and the 11.2M PCM data with the crossfade unit 58.

Specifically, the delay units 56 and 57 delay the fed 11.2M DSD data and 11.2M PCM data a predetermined common amount. Furthermore, one of the delay units 56 and 57 to which audio data to be faded in is input also adjusts the delay amount D fed from the delay control unit 76. An instruction of performing adjustment of the delay amount D is fed from the control unit 50.

The delay unit 56 subsequently outputs the 11.2M DSD data delayed a first delay amount to the crossfade unit 58 and the delay unit 60. The delay unit 57 subsequently outputs the 11.2M PCM data delayed a second delay amount to the crossfade unit 58.

The crossfade unit 58 performs crossfade processing on the 11.2M DSD data and the 11.2M PCM data. In a case of switching from the first audio data to the second audio data, the crossfade unit 58 performs fade-out processing whereby the signal level of the first audio data is gradually reduced with time, performs fade-in processing whereby the signal level of the second audio data is gradually increased from zero level with time, and mixes the first audio data after the fade-out processing and the second audio data after the fade-in processing. The crossfade signal obtained as a result of mixing is output to the delta-sigma modulation unit 59. In a case where audio data is input from only one of the delay unit 56 or the delay unit 57, the crossfade unit 58 outputs the audio data to the delta-sigma modulation unit 59 as it is.

The delta-sigma modulation unit 59 performs delta-sigma modulation on the audio data (crossfade signal), which is an output of the crossfade unit 58, generates 11.2M DSD data, and outputs it to the signal matching detection unit 61 and the switch unit 62.

The delay unit 60 delays 11.2M DSD data fed from the delay unit 56 a time corresponding to the processing time of the crossfade processing of the crossfade unit 58 and the delta-sigma modulation processing of the delta-sigma modulation unit 59, and outputs the 11.2M DSD data after delay to the signal matching detection unit 61 and the switch unit 62.

The signal matching detection unit 61 detects matching between 11.2M DSD data, which is an output of the delay unit 60, which is the same DSD data as that input to the crossfade unit 58, and 11.2M DSD data, which is a crossfade signal modulated by the delta-sigma modulation unit 59. In a case where matching of 11.2M DSD data is detected, the signal matching detection unit 61 outputs a matching detection signal indicative of data matching to the switch unit 62.

The switch unit 62, according to the control under the signal matching detection unit 61, switches a signal input to the subsequent delta-sigma demodulator 64. The switch unit 62 selects any one of 11.2M DSD data, which is an output of the delay unit 60, or 11.2M DSD data, which is an output of the delta-sigma modulation unit 59, and outputs the selected 11.2M DSD data to the subsequent delta-sigma demodulator 64.

During a period of time in which the crossfade unit 58 executes the crossfade processing and during a period of time in which the reproduction apparatus 11 acquires and reproduces the AAC data, the switch unit 62 selects 11.2M DSD data, which is an output of the delta-sigma modulation unit 59, and outputs it to the delta-sigma demodulator 64.

Meanwhile, during a period of time in which the reproduction apparatus 11 acquires and reproduces any of 11.2M DSD data, 5.6M DSD data, or 2.8M DSD data, because the acquired audio data is DSD data and does not require delta-sigma modulation, the switch unit 62 selects 11.2M DSD data, which is an output of the delay unit 60, and outputs it to the delta-sigma demodulator 64.

In a case where a matching detection signal is fed from the signal matching detection unit 61, the switch unit 62 switches an acquisition target for audio data output to the subsequent delta-sigma demodulator 64 from the delta-sigma modulation unit 59 side to the delay unit 60 side.

Meanwhile, in a case where an instruction of selecting the delta-sigma modulation unit 59 side is fed from the control unit 50, the switch unit 62 switches an acquisition target for audio data output to the delta-sigma demodulator 64 from the delay unit 60 side to the delta-sigma modulation unit 59 side. In a case of acquiring and reproducing the AAC data (including a crossfade period), the control unit 50 feeds an instruction of selecting the delta-sigma modulation unit 59 side to the switch unit 62.

The clock supply unit 63 feeds the clock signal CLK2 corresponding to the DSD data having a maximum bit rate that can be reproduced by the reproduction apparatus 11, to the delta-sigma demodulator 64. In the present embodiment, a maximum bit rate that can be reproduced by the reproduction apparatus 11 is 11.2 Mbps. Therefore, the clock supply unit 63 generates a clock signal CLK2 of about 11.2 MHz and feeds it to the delta-sigma demodulator 64.

The delta-sigma demodulator 64 demodulates (delta-sigma demodulation) 11.2M DSD data fed from the switch unit 62 using the clock signal CLK2 fed from the clock supply unit 34, and outputs a demodulation result to the subsequent analog LPF 27 (Fig. 1). The delta-sigma demodulator 64 can, for example, include a finite impulse response (FIR) digital filter.

The reproduction apparatus 11 includes the aforementioned configuration.

<3. Example of processing of signal matching detection unit>

Processing of detecting matching of two 11.2M DSD data performed by the signal matching detection unit 61 is described with reference to Figs. 5 to 11.

In Figs. 5 to 11, among the two 11.2M DSD data to be compared by the signal matching detection unit 61, 11.2M DSD data, which is an output of the delay unit 60, is called original DSD data SA and 11.2M DSD data, which is an output of the delta-sigma modulation unit 59, is called PCM converted DSD data SB.

The signal matching detection unit 61 monitors the original DSD data SA and the PCM converted DSD data SB over the predetermined number of samples with respect to each sampling timing, and, when matching of serial data, e.g., four samples, is detected, outputs a matching detection signal ST indicative of detection of data matching to the switch unit 62.

Furthermore, the signal matching detection unit 61 monitors the original DSD data SA and the PCM converted DSD data SB over the predetermined number of samples with respect to each sampling timing, and, when matching of serial data, e.g., four samples, cannot be detected, performs re-monitoring over a next predetermined number of samples with respect to each sampling timing, and, when matching of level, e.g., of four samples, is detected, outputs a matching detection signal ST indicative of data matching to the switch unit 62.

Fig. 5 is a table for explaining the level of 1-bit signal.

The amplitude of a 1-bit signal includes sample value 1, which is +1, and sample value 0, which is -1. Therefore, for example, with respect to the 1-bit signals of four samples illustrated in the first row of the table illustrated in Fig. 5, a signal level can be calculated as illustrated in the third row of the table illustrated in Fig. 5.

Furthermore, for example, when matching of level of the four samples is not detected, but, for example, matching of frequency of appearance of sample value 0 and sample value 1 of the four samples is detected, the results of detection are equivalent. As illustrated in the second row of the table illustrated in Fig. 5, this is frequency of appearance of sample value 0 and sample value 1 of the 1-bit signals of the four samples.

In the present embodiment, the signal matching detection unit 61, first, over a predetermined number of samples, performs detection of data matching over a plurality of samples of the original DSD data SA and the PCM converted DSD data SB, and, when serial data matching is detected, generates a matching detection signal ST indicative of detection of data matching. In a case where, over a predetermined number of samples, matching over a plurality of samples of the original DSD data SA and the PCM converted DSD data SB cannot be detected, next, the signal matching detection unit 61 performs detection of level matching over a plurality of samples of the original DSD data SA and the PCM converted DSD data SB over a predetermined number of samples, and, when level matching is detected, generates a matching detection signal ST indicative of detection of level matching.

The operation of the signal matching detection unit 61 is described in detail with reference to the drawings.

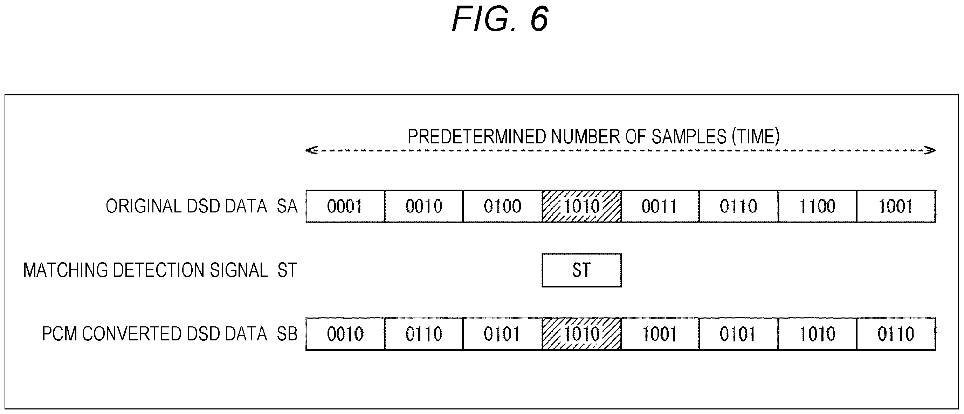

Figs. 6 to 11 are diagrams explaining the operation of the signal matching detection unit 61.

In Figs. 6 to 11, for the sake of simplicity, over a predetermined number of samples, for example, serial data matching of four samples and signal level matching of four samples are monitored and detected with forward movement of four samples. A format for recording a 1-bit signal on a computer, in many cases, collectively handles 1-bit signals of eight samples as 1-byte data. Data access of a computer is generally in units of bytes, and the signal matching detection unit 61 monitors and detects, over a predetermined number of samples, for example, serial data matching of four samples and signal level matching of four samples with forward movement of four samples. The signal matching detection unit 61, by performing monitoring and detection with forward movement of four samples, can efficiently perform processing with reference to MSB 4 bits and LSB 4 bits of byte data without crossing a byte boundary.

The signal matching detection unit 61 monitors original DSD data SA and PCM converted DSD data SB illustrated in Fig. 6 over a predetermined number of samples with forward movement of four samples with respect to each sampling timing. The signal matching detection unit 61, when detecting serial data matching of four samples at timing of four samples of 1-bit signals (1010), which is fourth from the left, generates a matching detection signal ST indicative of detection of data matching and outputs it to the switch unit 62.

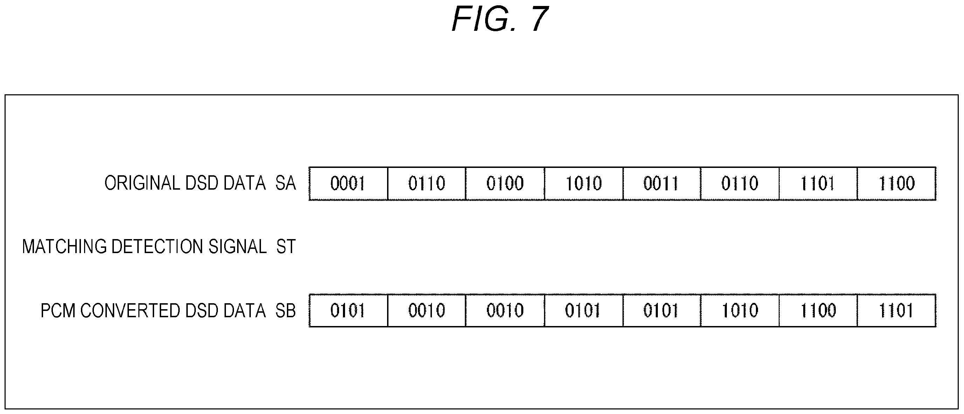

However, in some cases, the signal matching detection unit 61 compares signals for which serial data matching of four samples cannot be detected. For example, as a result of monitoring of the original DSD data SA and the PCM converted DSD data SB illustrated in Fig. 7 over a predetermined number of samples with respect to each sampling timing with forward movement of four samples, the signal matching detection unit 61 determines that serial data matching of four samples cannot be detected.

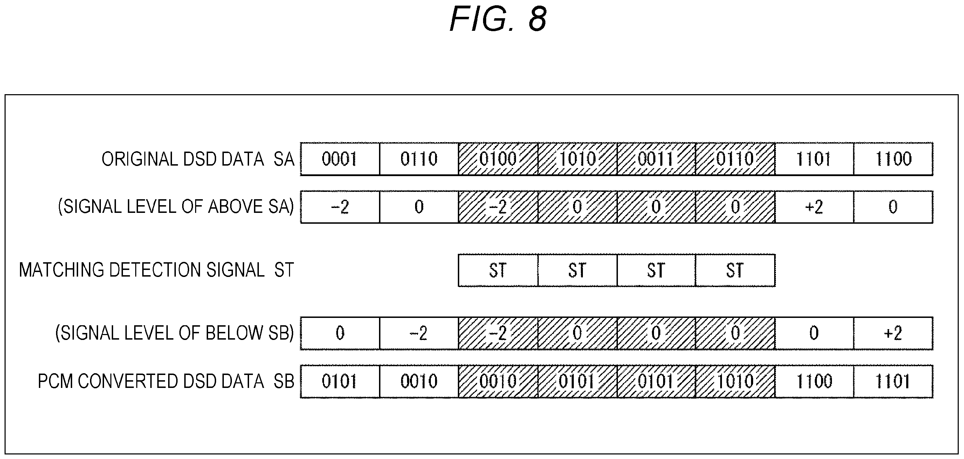

In this case, the signal matching detection unit 61 re-monitors the original DSD data SA and the PCM converted DSD data SB illustrated in Fig. 8 over a predetermined number of samples with respect to each sampling timing with forward movement of four samples. The signal matching detection unit 61, when detecting signal level matching at the timing of four samples of 1-bit signals (signal level-2), which is third from the left, generates a matching detection signal ST indicative of detection of level matching and feeds it to the switch unit 62.

The timing of detecting signal level matching by the signal matching detection unit 61 may be the timing of four samples of 1-bit signals, which is third from the left in Fig. 8, at which matching is detected first, or may be any timing up to four samples of 1-bit signals, which is sixth from the left in Fig. 8, where signal level matching continues. In order to perform more effective switching, a vicinity near the middle of four samples of 1-bit signals where signal level matching continues at most, is safe, and in the case of Fig. 8, it is desirable that the signal matching detection unit 61 detect signal level matching at the timing of four samples of 1-bit signals, which is fourth from the left, for example. This is because, in a case where the signal is returned to analog, it can be different data as it closes to the boundary, and when the timing of detecting signal level matching is set to a vicinity of the middle, it is considered that there is a small difference in signal before and after switching.

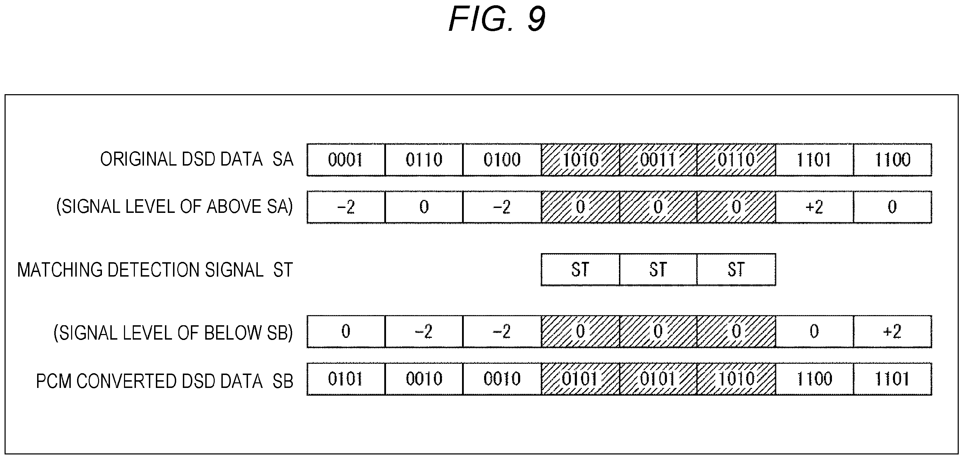

Furthermore, the signal matching detection unit 61 may select the detection timing of signal level matching from four samples of 1-bit signals where the same signal level matching continues. In an example illustrated in Fig. 9, the signal levels from fourth to sixth from the left continue matching at 0. In this case, the detection timing of signal level matching by the signal matching detection unit 61 may be the timing of four samples of 1-bit signals, which is fourth from the left in Fig. 9, at which matching is detected first, or may be any timing up to four samples of 1-bit signals, which is sixth from the left in Fig. 9, where signal level matching continues. In order to perform more effective switching, a vicinity near the middle of four samples of 1-bit signals where signal level matching continues at most is safe, and in the case of Fig. 9, it is desirable that the signal matching detection unit 61 detect signal level matching at the timing of four samples of 1-bit signals, which is fifth from the left, for example. This is because, similarly to the case where switching is performed in a vicinity of the middle of 1-bit signals where signal level matching continues at most, in a case where the signal is returned to analog, it can be different data as it closes to the boundary, and when the timing of detecting signal level matching is set to a vicinity of the middle, it is considered that there is a small difference in signal before and after switching.

Alternatively, furthermore, the signal matching detection unit 61 may detect matching of frequency of appearance of sample value 0 and sample value 1 of four samples instead of detecting level matching over a plurality of samples of the original DSD data SA and the PCM converted DSD data SB.

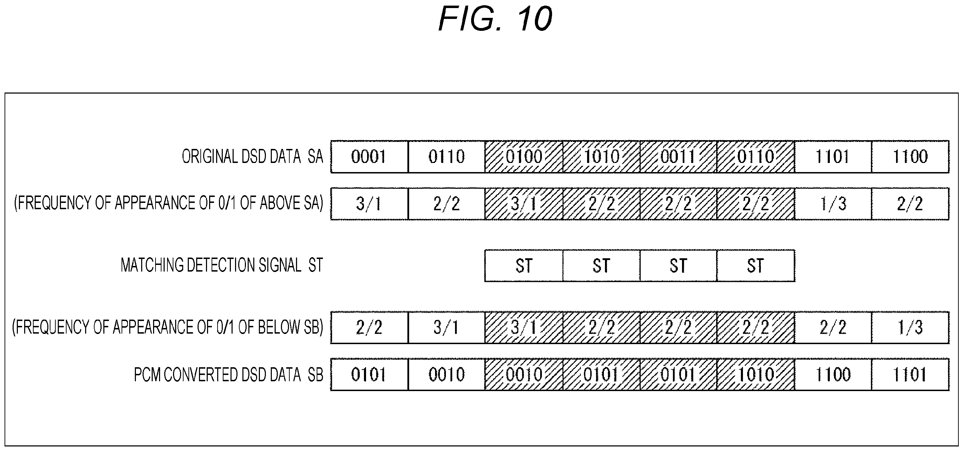

For example, the signal matching detection unit 61 monitors the original DSD data SA and the PCM converted DSD data SB illustrated in Fig. 10 over a predetermined number of samples with respect to each sampling timing with forward movement of four samples. Then, the signal matching detection unit 61, when detecting signal level matching at the timing of four samples of 1-bit signals, which is third from the left (frequency of appearance of 0/1, which is the number of appearances of 0 and 1, is 3/1), generates matching detection signal ST indicative of matching of frequency of appearance and feeds it to the switch unit 62.

As the detection timing for matching of frequency of appearance of 0/1, the signal matching detection unit 61 may have timing of four samples of 1-bit signals, which is third from the left in Fig. 10, at which matching is detected first, or any timing up to four samples of 1-bit signals, which is sixth from the left in Fig. 10, where matching of frequency of appearance of 0/1 continues. For more effective switching, a vicinity of the middle of the four samples of 1-bit signals where matching continues at most is safe, and in the case of Fig. 10, it is desirable that the signal matching detection unit 61 detect matching of frequency of appearance of 0/1 of four samples of 1-bit signals, which is fourth from the left, for example.

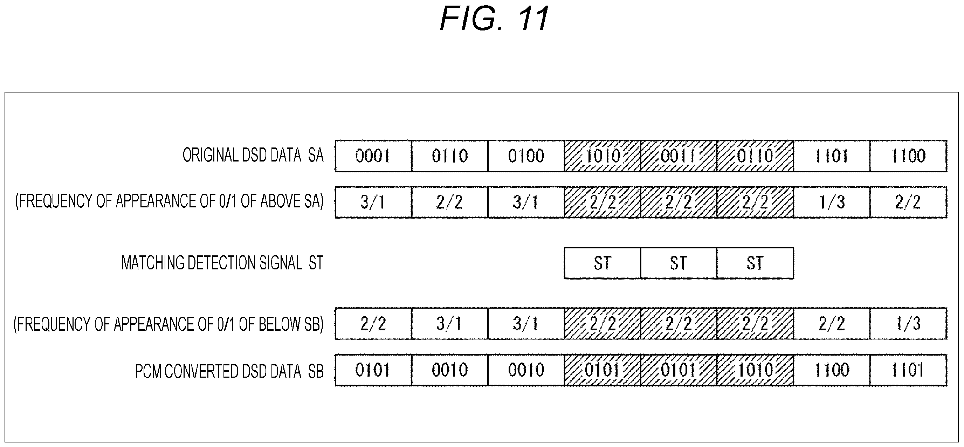

Furthermore, the signal matching detection unit 61 may select detection timing for matching of frequency of appearance of 0/1 from four samples of 1-bit signals where matching of the same frequency of appearance of 0/1 continues. In the example illustrated in Fig. 11, the frequency of appearance of 0/1 is 2/2 such that matching continues from fourth to sixth from the left. In this case, the detection timing for matching of frequency of appearance of 0/1 by the signal matching detection unit 61 may be the timing of four samples of 1-bit signals, which is fourth from the left where matching is detected first or may be any timing up to four samples of 1-bit signals, which is sixth from the left where matching of the frequency of appearance of 0/1 continues. For more effective switching, a vicinity of the middle of the four samples of 1-bit signals where matching continues at most is safe, and in the case of Fig. 11, it is desirable that the signal matching detection unit 61 detect matching of the frequency of appearance of 0/1 at the timing of four samples of 1-bit signals, which is fifth from the left, for example.

Note that, for example, in a case where detection target is a sample in which the pattern illustrated in Fig. 8 and the pattern illustrated in Fig. 9 continue, the signal matching detection unit 61 may select either of them as a matching sample and may select a portion where matching continues the longest as a matching sample.

<4. DSD data reproduction processing>

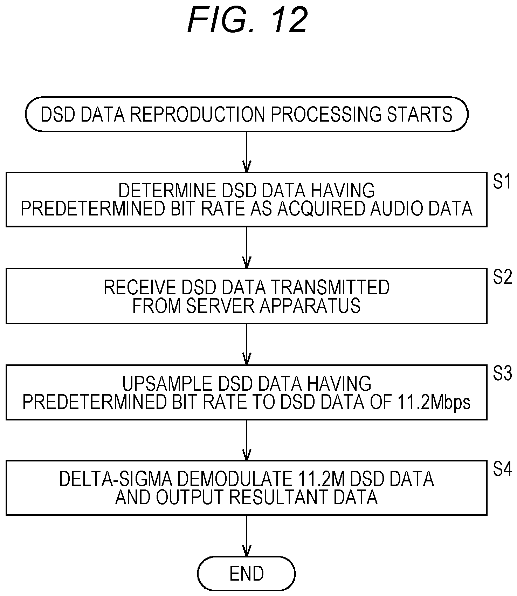

Next, DSD data reproduction processing in which the reproduction apparatus 11 acquires and reproduces DSD data is described with reference to the flowchart of Fig. 12. The processing of Fig. 12 is executed when, for example, in an operation unit of the reproduction apparatus 11, a user gives an instruction of reproducing predetermined content stored in the server apparatus 12. The reproduction processing of Fig. 12 does not include switch processing between AAC data and DSD data of the content for which a reproduction instruction has been given.

First of all, in step S1, the control unit 50 determines DSD data having a predetermined bit rate as acquired audio data from among a plurality of types of audio data having different bit rates corresponding to the content for which a reproduction instruction has been given, and gives an instruction to the communication unit 51 to perform acquisition. In the present embodiment, acquisition of any of 11.2M DSD data, 5.6M DSD data, or 2.8M DSD data is determined, and an instruction is given to the communication unit 51 from the control unit 50.

In step S2, the communication unit 51, under the control by the control unit 50, transmits a request of demanding DSD data having a predetermined bit rate to the server apparatus 12. Furthermore, the communication unit 51 receives (acquires) DSD data transmitted from the server apparatus 12 according to the demand, and feeds the DSD data to the DSD upsampling unit 52.

In step S3, the DSD upsampling unit 52 upsamples the DSD data having the predetermined bit rate fed from the communication unit 51 to DSD data having a maximum bit rate that can be reproduced by the reproduction apparatus 11, and feeds the DSD data after the upsampling processing to the delay amount detection unit 55 and the delay unit 56.

The maximum bit rate that can be reproduced by the reproduction apparatus 11 in the present embodiment is 11.2 Mbps. Accordingly, the DSD upsampling unit 52 upsamples the DSD data having the predetermined bit rate fed from the communication unit 51 to DSD data of 11.2 Mbps. In a case where the DSD data fed from the communication unit 51 is 11.2M DSD data, the DSD upsampling unit 52 outputs the fed DSD data as it is.

In step S4, the delta-sigma demodulator 64 performs delta-sigma demodulation on the 11.2M DSD data fed via the delay units 56 and 60, and the switch unit 62 by using the clock signal CLK2 fed from the clock supply unit 63, and outputs the DSD data.

The output analog audio signal is fed to the analog LPF 27, and after a high-frequency component is removed by the analog LPF 27, the power is amplified by the power amplifier 28. Then, on the basis of the power-amplified analog audio signal, the sound of the content for which the reproduction instruction has been given is output from the speaker 29.

In a case where the reproduction apparatus 11 acquires and reproduces DSD data only, the processing below is executed.

<5. AAC data reproduction processing>

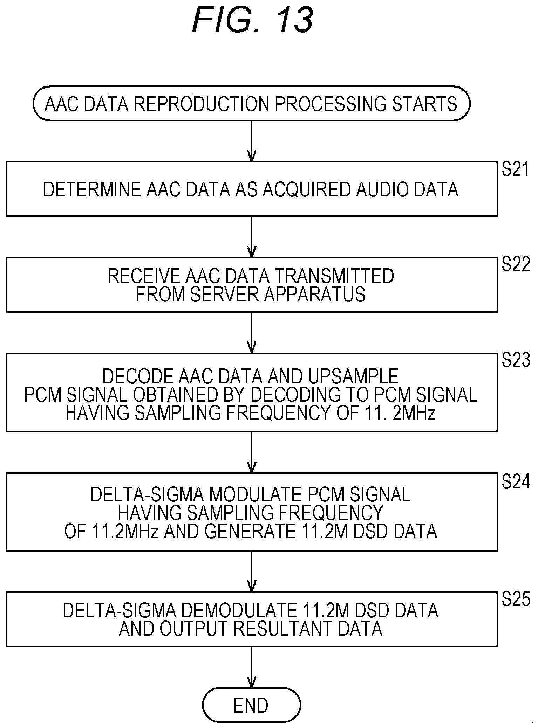

Next, the AAC data reproduction processing in which the reproduction apparatus 11 acquires and reproduces the AAC data is described with reference to the flowchart of Fig. 13. The processing of Fig. 13 is executed when, for example, in the operation unit of the reproduction apparatus 11, a user gives an instruction of reproducing predetermined content stored in the server apparatus 12. The reproduction processing of Fig. 13 does not include switch processing between AAC data and DSD data of the content for which the reproduction instruction has been given.

First of all, in step S21, the control unit 50 determines AAC data as acquired audio data from among a plurality of types of audio data having different bit rates corresponding to the content for which the production instruction has been given, and gives an instruction to the communication unit 51 to perform acquisition.

In step S22, the communication unit 51, under the control by the control unit 50, transmits a request for demanding AAC data to the server apparatus 12. Furthermore, the communication unit 51 receives (acquires) the AAC data transmitted from the server apparatus 12 according to the demand, and feeds the AAC data to the decode unit 53.

In step S23, the decode unit 53 decodes the AAC data fed from the communication unit 51 by a decoding method corresponding to an encoding method, and outputs a PCM signal obtained by decoding to the PCM upsampling unit 54.

The PCM upsampling unit 54 upsamples the PCM signal fed from the decode unit 53 to the same frequency as the sampling frequency of the DSD data output by the DSD upsampling unit 52, and outputs the PCM signal to the delay amount detection unit 55 and the delay unit 57. More specifically, the PCM upsampling unit 54 performs upsampling to a PCM signal having sampling frequency 11.2 MHz, and outputs the PCM signal to the delay amount detection unit 55 and the delay unit 57.

In step S24, the delta-sigma modulation unit 59 performs delta-sigma modulation on the PCM signal having sampling frequency 11.2 MHz fed via the delay unit 57 and the crossfade unit 58 to generate 11.2M DSD data, and outputs it to the signal matching detection unit 61 and the switch unit 62. The control unit 50, when acquiring and reproducing the AAC data only, feeds an instruction of selecting the output of the delta-sigma modulation unit 59 to the switch unit 62. The switch unit 62 selects the output of the delta-sigma modulation unit 59, and outputs 11.2M DSD data, which is fed from the delta-sigma modulation unit 59, to the delta-sigma demodulator 64.

In step S25, the delta-sigma demodulator 64 demodulates (delta-sigma demodulation) the 11.2M DSD data fed via the crossfade unit 58 by using the clock signal CLK2 fed from the clock supply unit 34, and outputs a demodulation result to the subsequent analog LPF 27 (Fig. 1) .

The output analog audio signal is fed to the analog LPF 27, and after a high-frequency component is removed by the analog LPF 27, the power is amplified by the power amplifier 28. Then, on the basis of the power-amplified analog audio signal, the sound of the content for which the reproduction instruction has been given is output from the speaker 29.

In a case where the reproduction apparatus 11 acquires and reproduces AAC data only, the aforementioned processing is executed.

<6. Reproduction switch processing>

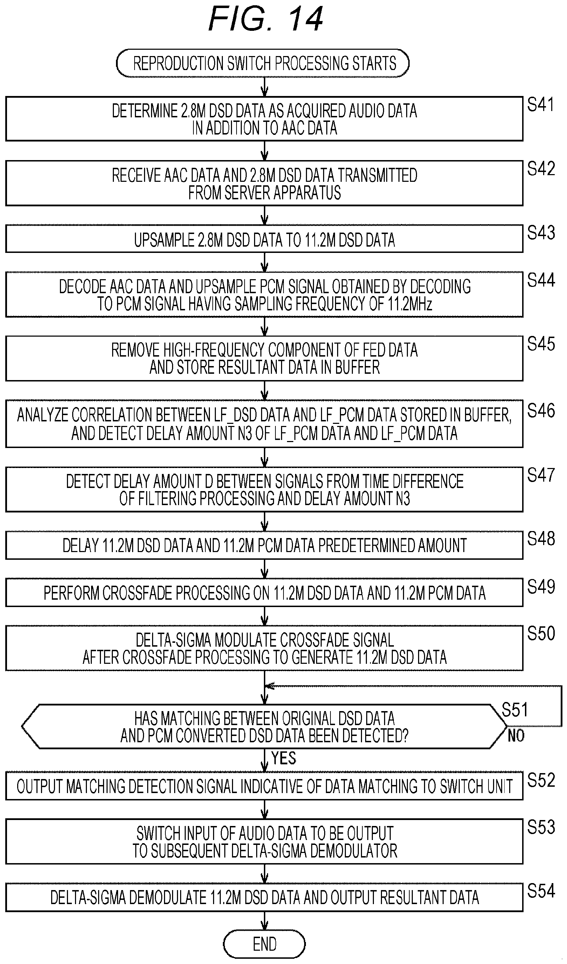

Next, with reference to the flowchart of Fig. 14, the reproduction switch processing is described in which, as audio data corresponding to content for which a reproduction instruction is given, reproduction data is switched from AAC data to DSD data having a predetermined bit rate according to the communication capacity of the network 26.

The processing of Fig. 14 is executed when, for example, the control unit 50 determines switching from AAC data to DSD data having a predetermined bit according to the communication capacity of the network 26. Note that, in the example of Fig. 14, the control unit 50 is described to have determined switching from AAC data to 2.8M DSD data.

First, in step S41, the control unit 50 determines 2.8M DSD data, as acquired audio data, in addition to AAC data acquired up to then, and gives an instruction to the communication unit 51 to perform acquisition.

In step S42, the communication unit 51, under the control by the control unit 50, transmits a request of demanding AAC data and 2.8M DSD data to the server apparatus 12. Furthermore, the communication unit 51 receives (acquires) AAC data and 2.8M DSD data transmitted from the server apparatus 12 according to the demand. The acquired 2.8M DSD data is fed to the DSD upsampling unit 52, and the AAC data is fed to the decode unit 53.

In step S43, the DSD upsampling unit 52 upsamples the 2.8M DSD data fed from the communication unit 51 to 11.2M DSD data, and feeds the 11.2M DSD data after the upsampling processing to the delay amount detection unit 55 and the delay unit 56.

In step S44, the decode unit 53 decodes the AAC data fed from the communication unit 51 by a decoding method corresponding to an encoding method, and outputs a PCM signal obtained by decoding to the PCM upsampling unit 54. Furthermore, in step S44, the PCM upsampling unit 54 upsamples the PCM signal fed from the decode unit 53 to a PCM signal having sampling frequency 11.2 MHz, and outputs the PCM signal to the delay amount detection unit 55 and the delay unit 57.

The processing of the steps S43 and S44 may be executed in parallel. Furthermore, the steps S43 and S44 may be processed in a reverse order.

In step S45, the LPFs 71 and 72 remove a high-frequency component of the fed data and store the data in a buffer. More specifically, the LPF 71 removes a high-frequency component of the 11.2M DSD data fed from the DSD upsampling unit 52, and stores the 11.2M DSD data (LF_DSD data) after high frequency removal in a DSD buffer 73. The LPF 72 removes a high-frequency component of the 11.2M PCM data fed from the PCM upsampling unit 54 and stores the 11.2M PCM data (LF_PCM data) after high frequency removal in a PCM buffer 74.

In step S46, the correlation analysis unit 75 analyzes a correlation between the LF_DSD data stored in the DSD buffer 73 and the LF_PCM data stored in the PCM buffer 74, and detects the delay amount N3 of the LF_PCM data and the LF_PCM data. The detected delay amount N3 is fed to the delay control unit 76.

In step S47, the delay control unit 76 detects a delay amount D between signals from a time difference (N1/2 to N2/2) of filtering processing of the LPF 71 and the LPF 72 and the delay amount N3 detected by the correlation analysis unit 75, and outputs the delay amount D to the delay units 56 and 57.

In step S48, the delay units 56 and 57 delay the 11.2M DSD data and the 11.2M PCM data a predetermined amount. More specifically, the delay units 56 and 57 delay the fed 11.2M DSD data and 11.2M PCM data a common predetermined amount. Furthermore, the delay unit 56 on the fade-in side further adjusts the delay amount D fed from the delay control unit 76. An instruction of performing adjustment of the delay amount D is fed from the control unit 50.

In step S49, the crossfade unit 58 performs crossfade processing on the 11.2M DSD data and the 11.2M PCM data, and outputs a crossfade signal after the processing to the delta-sigma-modulation unit 59.

In step S50, the delta-sigma modulation unit 59 performs delta-sigma modulation on the crossfade signal after the crossfade processing input from the crossfade unit 58 to generate 11.2M DSD data, and outputs it to the signal matching detection unit 61 and the switch unit 62.

In step S51, the signal matching detection unit 61 executes processing of detecting matching between the original DSD data, which is 11.2M DSD data fed from the delay unit 56 via the delay unit 60, and the PCM converted DSD data, which is 11.2M DSD data, fed from the delta-sigma modulation unit 59, and determines whether the matching is detected.

In step S51, in a case where it is determined that matching between the original DSD data and the PCM converted DSD data is not detected, the processing of step S51 is repeated.

Meanwhile, in a case where it is determined in step S51 that matching between the original DSD data and the PCM converted DSD data is detected, the processing proceeds to step S52, and the signal matching detection unit 61 outputs a matching detection signal indicative of data matching to the switch unit 62.

In step S53, the switch unit 62 switches input of audio data to be output to the subsequent delta-sigma demodulator 64, from the output of the delta-sigma modulation unit 59 to the output of the delay unit 60. The switch unit 62 outputs the 11.2M DSD data, which is fed from the delay unit 60, to the delta-sigma demodulator 64.

In step S54, the delta-sigma demodulator 64 demodulates (delta-sigma demodulation) 11.2M DSD data fed from the switch unit 62 by using the clock signal CLK2, and outputs a demodulation result to the analog LPF 27, which is external of the apparatus.

Thus, the reproduction switch processing ends.

The aforementioned example is described by way of an example of switching from AAC data to 2.8M DSD data, but can be executed similarly in a case of switching from 2.8M DSD data to AAC data. Furthermore, it is similar also in a case where the DSD data acquired from the server apparatus 12 is DSD data other than 2.8M DSD data.

By the reproduction switch processing of the reproduction apparatus 11, DSD data and PCM data (AAC data) having different data capacities can properly be switched and acquired depending on the communication capacity of the network 26, and can be reproduced and output as a sound of content.

With the reproduction apparatus 11, only when the delta-sigma demodulation is executed using the clock signal CLK2 corresponding to the DSD data having a maximum bit rate among a plurality of DSD data and PCM data having different bit rates of the same content stored in the server apparatus 12, also in a case where the DSD data and PCM data having different bit rates are properly switched and received, smooth switching reproduction (seamless reproduction) of content can be performed without generation of noises.

<Variation>

In the aforementioned embodiment, in the delay amount detection unit 55, both 11.2M DSD data fed from the DSD upsampling unit 52 and 11.2M PCM data fed from the PCM upsampling unit 54 are narrowed to a signal having a predetermined frequency or less from the beginning by the LPFs 71 and 72, and the phases of the 11.2M DSD data and the 11.2M PCM data are compared.

However, a frequency band at the time of comparing the phases of the 11.2M DSD data and the 11.2M PCM data can be divided into several stages such that the frequency band is gradually narrowed to compare the phases.

The DSD data, because of the characteristic of the delta-sigma modulator, has a characteristic in which quantization noise is pushed out by high frequency. Accordingly, first, the high-frequency component removal processing for the 11.2M PCM data by the LPF 72 may be omitted, and only the high-frequency component removal for the 11.2M DSD data by the LPF 71 may be performed to compare the phases of the 11.2M DSD data and the 11.2M PCM data.

Specifically, for example, the LPF 71 narrows the 11.2M DSD data fed from the DSD upsampling unit 52 to a signal having a frequency band of equal to or less than 1/2 of sampling frequency 44.1 kHz of the PCM signal. The correlation analysis unit 75 analyzes a correlation between the 11.2M PCM data after high frequency removal and the 11.2M PCM data from which a high frequency is not removed, and detects the delay amount N3.

Then, in a case where a certain or more correlation is not obtained, next, the LPF 72 is used such that the LPF 71 and the LPF 72 narrow the data to a frequency band (e.g., 2 kHz) or below, which is lower than 1/2 of sampling frequency 44.1 kHz, and the correlation analysis unit 75 compares the phases of the 11.2M DSD data after the high frequency removal and the 11.2M PCM data after the high frequency removal.

Thus, when the frequency band is gradually narrowed in several stages and the phases are compared, the delay amount N3 can be easily detected within one frame.

<7. Detailed configuration example of reproduction apparatus in a case where maximum bit rate is 5.6 Mbps>

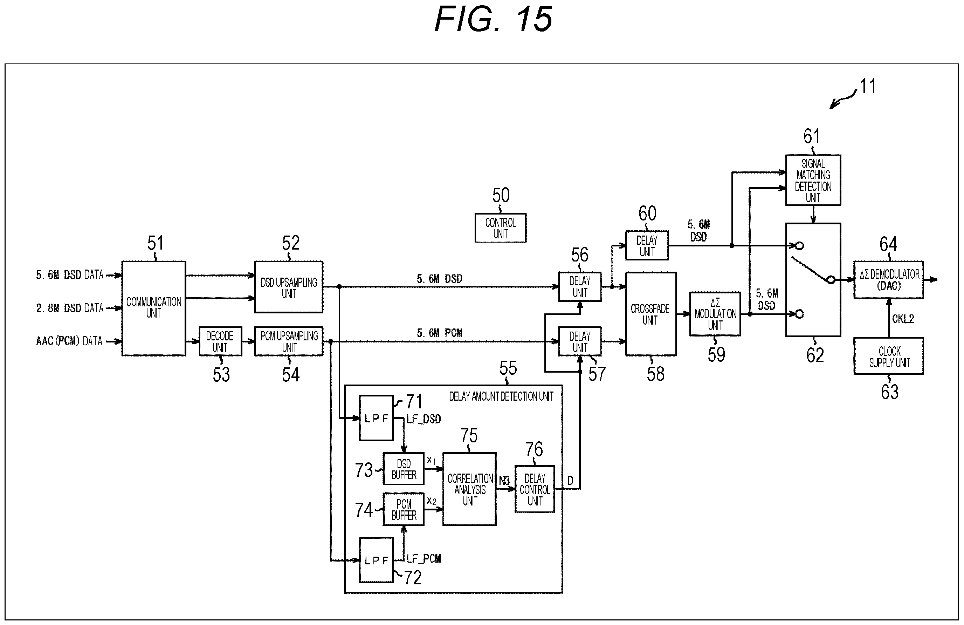

Fig. 15 is a block diagram illustrating a detailed configuration example of the reproduction apparatus 11 in a case where the maximum bit rate of the DSD data that can be reproduced is 5.6 Mbps.

In Figs. 15 to 17, parts corresponding to those of Fig. 3 are designated by the same reference numerals, and in the description of Figs. 15 to 17, a description is given with a focus on parts different from those of Fig. 3.

In a case where the maximum bit rate of DSD data that can be reproduced is 5.6 Mbps, the units of the reproduction apparatus 11 of Fig. 15 convert acquired audio data into 5.6 Mbps and perform reproduction processing.

The communication unit 51 acquires, as audio data, 5.6M DSD data or 2.8M DSD data, and feeds it to the DSD upsampling unit 52. Meanwhile, in a case where AAC data is acquired as audio data, the communication unit 51 feeds the acquired AAC data to the decode unit 53.

The DSD upsampling unit 52 upsamples the DSD data having a predetermined bit rate fed from the communication unit 51 to DSD data of 5.6 Mbps, and feeds 5.6M DSD data after the upsampling processing to the delay amount detection unit 55 and the delay unit 56.

The PCM upsampling unit 54 upsamples a quantization bit 16-bit PCM signal having sampling frequency 44.1 kHz fed from the decode unit 53 to sampling frequency 5.6 MHz, and outputs it to the delay amount detection unit 55 and the delay unit 57.

The correlation analysis unit 75 analyzes a correlation between the DSD data of 5.6 Mbps and the PCM data having sampling frequency 5.6 MHz, and detects the delay amount N3.

The crossfade unit 58 performs the crossfade processing on the 5.6M DSD data and the 5.6M PCM data.

The delta-sigma modulation unit 59 performs delta-sigma modulation on the audio data input from the crossfade unit 58 to generate 5.6M DSD data, and outputs it to the signal matching detection unit 61 and the switch unit 62.

The signal matching detection unit 61 detects matching between the 5.6M DSD data, which is an output of the delay unit 60, and the 5.6M DSD data, which is an output of the delta-sigma modulation unit 59, and outputs a matching detection signal indicative of data matching to the switch unit 62.

The switch unit 62, under the control by the signal matching detection unit 61, selects any one of the 5.6M DSD data, which is an output of the delay unit 60 or the 5.6M DSD data, which is an output of the delta-sigma modulation unit 59, and outputs the selected 5.6M DSD data to the subsequent delta-sigma demodulator 64.

The delta-sigma demodulator 64 performs delta-sigma demodulation on the 5.6M DSD data fed from the switch unit 62 by using the clock signal CLK2 of 5.6 MHz fed from the clock supply unit 34, and outputs a demodulation result.

<8. Detailed configuration example of reproduction apparatus in a case where maximum bit rate is 2.8 Mbps>

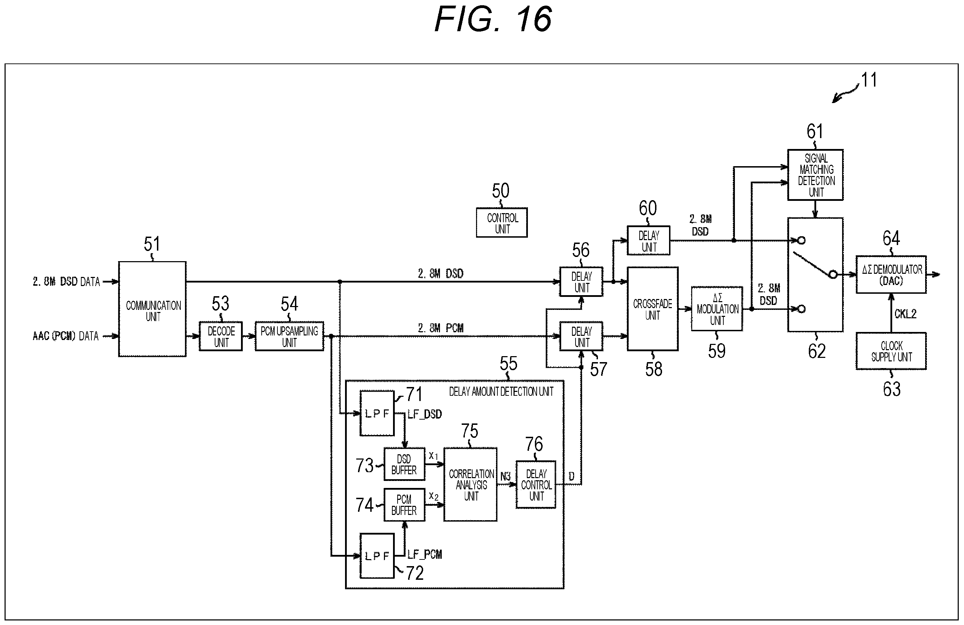

Fig. 16 is a block diagram illustrating a detailed configuration example of the reproduction apparatus 11 in a case where DSD data that can be reproduced is 2.8 Mbps only.

In a case where the maximum bit rate of DSD data that can be reproduced is 2.8 Mbps only, the units of the reproduction apparatus 11 of Fig. 16 convert acquired audio data to 2.8 Mbps and perform reproduction processing.

The communication unit 51 acquires, as audio data, 2.8M DSD data or AAC data, and feeds the 2.8M DSD data to the delay amount detection unit 55 and the delay unit 56 and feeds the AAC data to the decode unit 53. There is only one type of the bit rate of the DSD data to be acquired, and therefore the DSD upsampling unit 52 is omitted.

The PCM upsampling unit 54 upsamples the quantization bit 16-bit PCM signal having sampling frequency 44.1 kHz fed from the decode unit 53 to sampling frequency 2.8 MHz, and outputs it to the delay amount detection unit 55 and the delay unit 57.

The correlation analysis unit 75 analyzes a correlation between DSD data of 2.8 Mbps and PCM data having sampling frequency 2.8 MHz, and detects the delay amount N3.

The crossfade unit 58 performs the crossfade processing on the 2.8M DSD data and the 2.8M PCM data.

The delta-sigma modulation unit 59 performs delta-sigma modulation on the audio data input from the crossfade unit 58 to generate 2.8M DSD data, and outputs it to the signal matching detection unit 61 and the switch unit 62.

The signal matching detection unit 61 detects matching between the 2.8M DSD data, which is an output of the delay unit 60, and the 2.8M DSD data, which is an output of the delta-sigma modulation unit 59, and outputs a matching detection signal indicative of data matching to the switch unit 62.

The switch unit 62, under the control by the signal matching detection unit 61, selects any one of the 2.8M DSD data, which is an output of the delay unit 60 or the 2.8M DSD data, which is an output of the delta-sigma modulation unit 59, and outputs the selected 2.8M DSD data to the subsequent delta-sigma demodulator 64.

The delta-sigma demodulator 64 performs delta-sigma demodulation on the 2.8M DSD data fed from the switch unit 62 by using the clock signal CLK2 of 2.8 MHz fed from the clock supply unit 34, and outputs a demodulation result.

<9. Detailed configuration example of reproduction apparatus in a case where a plurality of PCM data having different bit rates is switched>

The aforementioned embodiment is an example in which the reproduction apparatus 11 switches one or more DSD data and AAC data, but the present technology can be applied to switching of only a plurality of PCM data having different bit rates.

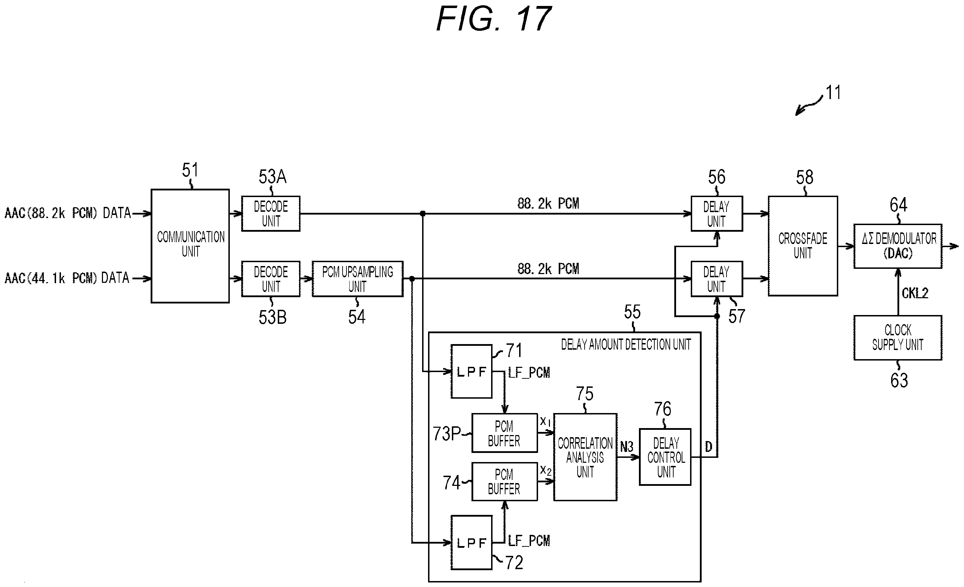

Fig. 17 is a block diagram illustrating a detailed configuration example of the reproduction apparatus 11 in a case where a plurality of PCM data having different bit rates is switched.

The reproduction apparatus 11 of Fig. 17 switches as necessary and reproduces AAC data obtained when PCM data having sampling frequency 88.2 kHz is compression-coded by AAC, the PCM data corresponding to the content for which a reproduction instruction has been given, and AAC data obtained when PCM data having sampling frequency 44.1 kHz is compression-coded by AAC.

In the following, for the sake of simplicity, AAC data obtained when the PCM data having sampling frequency 88.2 kHz is compression-coded by AAC is called Hi_AAC data and AAC data obtained when the PCM data having sampling frequency 44.1 kHz is compression-coded by AAC is called Lo_AAC data.

The units of the reproduction apparatus 11 convert acquired AAC data into PCM data having sampling frequency 88.2 kHz and perform the reproduction processing.

The communication unit 51 acquires, as audio data, the Hi_AAC data or the Lo_AAC data. The communication unit 51 feeds the acquired Hi_AAC data to a decode unit 53A and feeds the acquired Lo_AAC data to a decode unit 53B.

The decode units 53A and 53B are the same as the aforementioned decode unit 53 and decode the AAC data. The decode unit 53A decodes the Hi_AAC data, and outputs the resultant PCM data having sampling frequency 88.2 kHz to the delay amount detection unit 55 and the delay unit 56. The decode unit 53B decodes the Lo_AAC data, and outputs the resultant PCM data having sampling frequency 44.1 kHz to the PCM upsampling unit 54.

The PCM upsampling unit 54 upsamples the PCM signal having sampling frequency 44.1 kHz fed from the decode unit 53 to a PCM signal having sampling frequency 88.2 kHz, and outputs it to the delay amount detection unit 55 and the delay unit 57.

The LPF 71 removes a high-frequency component of the PCM data having sampling frequency 88.2 kHz, and stores the PCM data (LF_PCM) after removal in a buffer. The LPF 72 removes a high-frequency component of the upsampled PCM data having sampling frequency 88.2 kHz, and stores the PCM data (LF_PCM) after removal in a buffer. In Fig. 17, the DSD buffer 73 of the aforementioned embodiment is changed to a PCM buffer 73P that stores PCM data.

The correlation analysis unit 75 analyzes correction between the PCM data having sampling frequency 88.2 kHz fed from the decode unit 53A (hereinafter, the non-upsampled 88.2k PCM data) and the PCM data having sampling frequency 88.2 MHz fed from the PCM upsampling unit 54 (hereinafter, the upsampled 88.2k PCM data), and detects the delay amount N3.

The crossfade unit 58 performs the crossfade processing on the non-upsampled 88.2k PCM data and the upsampled 88.2k PCM data.

The delta-sigma demodulator 64 performs delta-sigma demodulation on the 88.2k PCM data fed from the crossfade unit 58 by using the clock signal CLK2 of 88.2 kHz fed from the clock supply unit 34, and outputs a demodulation result.

In a case of switching between a plurality of PCM data having different bit rates, the delta-sigma modulation unit 59, the signal matching detection unit 61, and the switch unit 62 are unnecessary.

Thus, the present technology can also be applied to a reproduction apparatus that switches only a plurality of PCM data having different bit rates and reproduces content.

<10. Example of application to computer>

The series of processing described above can be executed by hardware and it can also be executed by software. In a case where the series of processing described above is executed by software, a program constituting the software is installed in a computer. Here, the computer includes a computer mounted in dedicated hardware, for example, a general-purpose a personal computer that can execute various functions by installing the various programs, or the like.

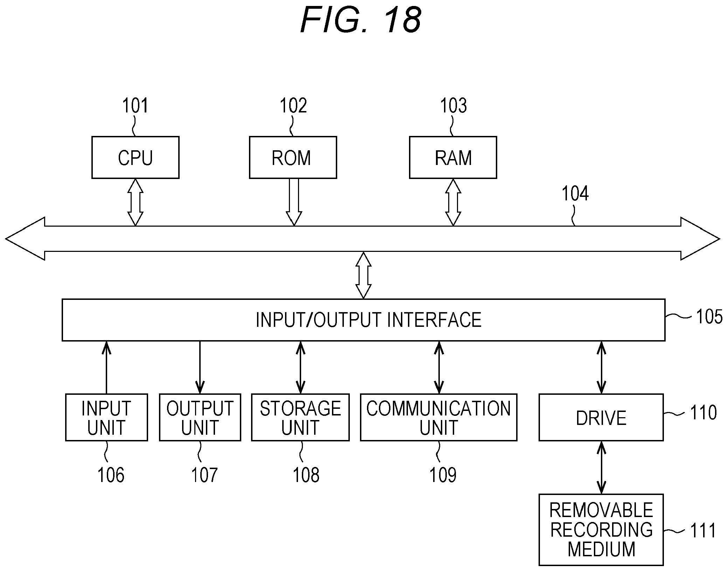

Fig. 18 is a block diagram illustrating a configuration example of hardware of a computer in which the series of processing described above is executed by a program.

In the computer, a CPU 101, a read only memory (ROM) 102, and a random access memory (RAM) 103 are mutually connected by a bus 104.

An input/output interface 105 is further connected to the bus 104. An input unit 106, an output unit 107, a storage unit 108, a communication unit 109, and a drive 110 are connected to the input/output interface 105.

The input unit 106 includes a keyboard, a mouse, a microphone, and the like. The output unit 107 includes a display, a speaker, and the like. The storage unit 108 includes a hard disk, a non-volatile memory, and the like. The communication unit 109 includes a network interface and the like. The drive 110 drives a removable recording medium 111 such as a magnetic disk, an optical disk, a magneto-optical disk, or a semiconductor memory.

In the computer configured in the manner described above, the processing such as the aforementioned DSD data reproduction processing, AAC data reproduction processing, or reproduction switch processing is performed, for example, such that the CPU 101 loads the program stored in the storage unit 108 into the RAM 103 via the input/output interface 105 and the bus 104 and executes the program.

In the computer, the program can be installed in the storage unit 108 via the input/output interface 105 when the removable recording medium 111 is mounted on the drive 110. Furthermore, the program can be received by the communication unit 109 and installed in the storage unit 108 via a wired or wireless transmission medium such as a local area network, the Internet, or digital satellite broadcasting. In addition, the program can be pre-installed on the ROM 102 or the storage unit 108.

Note that the program executed by the computer may be a program that is processed in chronological order along the order described in the present description or may be a program that is processed in parallel or at a required timing, e.g., when call is carried out.

In the aforementioned embodiment, a method compatible with the MPEG-DASH standards is adopted as the method for reception of a plurality of audio data having different sampling frequencies, but, of course, other methods may be adopted.

Furthermore, in the aforementioned embodiment, a description is given of the case where a plurality of audio data having different bit rates of the same content stored in the server apparatus 12 is data generated in synchronization. However, even if noise occurs due to lack of synchronization, in a case where the noise is in a negligible level in a range audible to a human, synchronization is not necessarily required as far as the sampling frequencies are the same.

As a configuration of application of the present technology, it is possible to adopt a configuration of cloud computing in which one function is shared and jointly processed by a plurality of apparatuses via a network.

Each step described in the above-described flowcharts can be executed by a single apparatus or shared and executed by a plurality of apparatuses. Moreover, in a case where a single step includes a plurality of pieces of processing, the plurality of pieces of processing included in the single step can be executed by a single device or can be divided and executed by a plurality of devices.

The effects described in the present description are merely illustrative and are not limitative, and effects not described in the present specification may be provided.

REFERENCE SIGNS LIST

| | |
|---|---|
| 1 | Reproduction system |
| 11 | Reproduction apparatus |
| 50 | Control unit |
| 51 | Communication unit |
| 52 | DSD upsampling unit |
| 53 | Decode unit |
| 54 | PCM upsampling unit |
| 55 | Delay amount detection unit |
| 56, 57 | Delay unit |
| 58 | Crossfade unit |
| 59 | Delta-sigma modulation unit |
| 60 | Delay unit |
| 61 | Signal matching detection unit |
| 62 | Switch unit |
| 64 | Delta-sigma demodulator |
| 71, 72 | LPF |
| 75 | Correlation analysis unit |
| 76 | Delay control unit |
| 101 | CPU |

| 102 | ROM |
| 103 | RAM |
| 106 | Input unit |
| 107 | Output unit |
| 108 | Storage unit |
| 109 | Communication unit |
| 110 | Drive |

**Claims**

1. A signal processing apparatus (11) comprising:

   an acquisition unit (51) configured to acquire a pulse code modulation, PCM, signal and a direct stream digital, DSD, signal;
   a PCM upsampling unit (54) configured to upsample the PCM signal to a sampling frequency of the DSD signal;
   a DSD filter (71) configured to remove a high-frequency component of the DSD signal;
   a delay amount detection unit (55) configured to analyze a correlation between the DSD signal from which a high-frequency component has been removed and the PCM signal after upsampling, and detect a delay amount; and
   a crossfade unit (58) configured to adjust timing of the DSD signal and the PCM signal after upsampling by using the detected delay amount and crossfade the DSD signal and the PCM signal after upsampling.

2. The signal processing apparatus (11) according to claim 1, further comprising:

   a PCM filter (72) configured to remove a high-frequency component of the PCM signal after upsampling, wherein the delay amount detection unit (55) is configured to analyze a correlation between the DSD signal from which a high-frequency component has been removed and the PCM signal after upsampling from which a high-frequency component has been removed, and detect a delay amount.

3. The signal processing apparatus (11) according to claim 1, further comprising:

   a DSD upsampling unit (52) configured to, in a case where the DSD signal acquired by the acquisition unit is not a DSD signal having a maximum bit rate for which the signal processing apparatus can perform signal processing, upsample the DSD signal acquired by the acquisition unit to a DSD signal having the maximum bit rate, wherein
   the PCM upsampling unit (54) is configured to upsample the PCM signal to a sampling frequency of the DSD signal after upsampling.

4. The signal processing apparatus (11) according to claim 1, further comprising:
   a delta-sigma modulation unit (59) configured to perform delta-sigma modulation on a crossfade signal, which is an output of the crossfade unit (58).

5. The signal processing apparatus (11) according to claim 4, further comprising:

   a signal matching detection unit (61) configured to detect matching between the DSD signal input to the crossfade unit and the crossfade signal modulated by the delta-sigma modulation unit; and
   a switch unit (62) configured to, in a case where matching is detected by the signal matching detection unit, switche a signal input to a delta-sigma demodulator (64) from the crossfade signal modulated by the delta-sigma modulation unit to the DSD signal input to the crossfade unit.

6. The signal processing apparatus (11) according to claim 1, further comprising:

   a decode unit (53) configured to decode the PCM signal compression-coded by a predetermined compression coding method, wherein
   the PCM upsampling unit (54) is configured to upsample the PCM signal decoded by the decode unit to a sampling frequency of the DSD signal.

7. The signal processing apparatus (11) according to claim 6, wherein the delay amount detection unit (55) is configured to treat a comparison length for analysis of a correlation between the DSD signal from which a high-frequency component has been removed and the PCM signal after upsampling, as a frame length of the compression coding method, and analyze the correlation.

8. A signal processing method comprising steps of, by a signal processing apparatus:

    acquiring a pulse code modulation, PCM, signal and a direct stream digital, DSD, signal;
    upsampling the PCM signal to a sampling frequency of the DSD signal;
    removing a high-frequency component of the DSD signal;
    analyzing a correlation between the DSD signal from which a high-frequency component has been removed and the PCM signal after upsampling, and detecting a delay amount; and
    adjusting timing of the DSD signal and the PCM signal after upsampling by using the detected delay amount, and crossfading the DSD signal and the PCM signal after upsampling.

9. A program for causing a computer to function as:

    an acquisition unit that acquires a pulse code modulation, PCM, signal and a direct stream digital, DSD, signal;
    a PCM upsampling unit that upsamples the PCM signal to a sampling frequency of the DSD signal;
    a DSD filter that removes a high-frequency component of the DSD signal;
    a delay amount detection unit that analyzes a correlation between the DSD signal from which a high-frequency component has been removed and the PCM signal after upsampling, and detects a delay amount; and
    a crossfade unit that adjusts timing of the DSD signal and the PCM signal after upsampling by using the detected delay amount and crossfades the DSD signal and the PCM signal after upsampling.

**Patentansprüche**

1. Signalverarbeitungsvorrichtung (11), welche umfasst:

    eine Erfassungseinheit (51), die dafür ausgelegt ist, ein Pulscodemodulationssignal, PCM-Signal, und ein Direct Stream Digital Signal, DSD-Signal, zu erfassen;
    eine PCM-Upsampling-Einheit (54), die dafür ausgelegt ist, die Abtastfrequenz des PCM-Signals auf eine Abtastfrequenz des DSD-Signals zu erhöhen;
    ein DSD-Filter (71), das dafür ausgelegt ist, eine hochfrequente Komponente des DSD-Signals zu entfernen;
    eine Verzögerungsbetrag-Detektionseinheit (55), die dafür ausgelegt ist, eine Korrelation zwischen dem DSD-Signal, aus welchem eine hochfrequente Komponente entfernt worden ist, und dem PCM-Signal nach dem Upsampling zu analysieren und einen Verzögerungsbetrag zu detektieren; und
    eine Überblendeinheit (58), die dafür ausgelegt ist, das Timing des DSD-Signals und des PCM-Signals nach dem Upsampling unter Verwendung des detektierten Verzögerungsbetrages anzupassen und das DSD-Signal und das PCM-Signal nach dem Upsampling zu überblenden.

2. Signalverarbeitungsvorrichtung (11) nach Anspruch 1, welche ferner umfasst:

    ein PCM-Filter (72), das dafür ausgelegt ist, eine hochfrequente Komponente des PCM-Signals nach dem Upsampling zu entfernen, wobei
    die Verzögerungsbetrag-Detektionseinheit (55) dafür ausgelegt ist, eine Korrelation zwischen dem DSD-Signal, aus welchem eine hochfrequente Komponente entfernt worden ist, und dem PCM-Signal nach dem Upsampling, aus welchem eine hochfrequente Komponente entfernt worden ist, zu analysieren und einen Verzögerungsbetrag zu detektieren.

3. Signalverarbeitungsvorrichtung (11) nach Anspruch 1, welche ferner umfasst:
    eine DSD-Upsampling-Einheit (52), die dafür ausgelegt ist, in einem Fall, wenn das von der Erfassungseinheit erfasste DSD-Signal kein DSD-Signal ist, das eine maximale Bitrate aufweist, für welche die Signalverarbeitungsvorrichtung eine Signalverarbeitung durchführen kann, die Abtastfrequenz des von der Erfassungseinheit erfassten DSD-Signals auf ein DSD-Signal zu erhöhen, das die maximale Bitrate aufweist, wobei die PCM-Upsampling-Einheit (54) dafür ausgelegt ist, die Abtastfrequenz des PCM-Signals auf eine Abtastfrequenz des DSD-Signals nach dem Upsampling zu erhöhen.

**4.** Signalverarbeitungsvorrichtung (11) nach Anspruch 1, welche ferner umfasst:
eine Delta-Sigma-Modulationseinheit (59), die dafür ausgelegt ist, eine Delta-Sigma-Modulation an einem Überblendsignal durchzuführen, welches ein Ausgang der Überblendeinheit (58) ist.

**5.** Signalverarbeitungsvorrichtung (11) nach Anspruch 4, welche ferner umfasst:

eine Signalübereinstimmungs-Detektionseinheit (61), die dafür ausgelegt ist, eine Übereinstimmung zwischen dem in die Überblendeinheit eingespeisten DSD-Signal und dem von der Delta-Sigma-Modulationseinheit modulierten Überblendsignal zu detektieren; und
eine Schalteinheit (62), die dafür ausgelegt ist, in einem Fall, wenn von der Signalübereinstimmungs-Detektionseinheit eine Übereinstimmung detektiert wird, ein Signal, das in einen Delta-Sigma-Demodulator (64) eingespeist wird, von dem von der Delta-Sigma-Modulationseinheit modulierten Überblendsignal zu dem in die Überblendeinheit eingespeisten DSD-Signal umzuschalten.

**6.** Signalverarbeitungsvorrichtung (11) nach Anspruch 1, welche ferner umfasst:

eine Decodiereinheit (53), die dafür ausgelegt ist, das PCM-Signal zu decodieren, das mit einem vorbestimmten Kompressionscodierverfahren kompressionscodiert wurde, wobei
die PCM-Upsampling-Einheit (54) dafür ausgelegt ist, die Abtastfrequenz des von der Decodiereinheit decodierten PCM-Signals auf eine Abtastfrequenz des DSD-Signals zu erhöhen.

**7.** Signalverarbeitungsvorrichtung (11) nach Anspruch 6, wobei die Verzögerungsbetrag-Detektionseinheit (55) dafür ausgelegt ist, eine Vergleichslänge für die Analyse einer Korrelation zwischen dem DSD-Signal, aus welchem eine hochfrequente Komponente entfernt worden ist, und dem PCM-Signal nach dem Upsampling als eine Rahmenlänge des Kompressionscodierverfahrens zu behandeln und die Korrelation zu analysieren.

**8.** Signalverarbeitungsverfahren, welches die von einer Signalverarbeitungsvorrichtung ausgeführten Schritte umfasst:

Erfassen eines Pulscodemodulationssignals, PCM-Signals, und eines Direct Stream Digital Signals, DSD-Signals;
Erhöhen der Abtastfrequenz des PCM-Signals auf eine Abtastfrequenz des DSD-Signals;
Entfernen einer hochfrequenten Komponente des DSD-Signals;
Analysieren einer Korrelation zwischen dem DSD-Signal, aus welchem eine hochfrequente Komponente entfernt worden ist, und dem PCM-Signal nach dem Upsampling, und Detektieren eines Verzögerungsbetrages; und
Anpassen des Timings des DSD-Signals und des PCM-Signals nach dem Upsampling unter Verwendung des detektierten Verzögerungsbetrages und Überblenden des DSD-Signals und des PCM-Signals nach dem Upsampling.

**9.** Programm zum Bewirken, dass ein Computer fungiert als:

eine Erfassungseinheit, welche ein Pulscodemodulationssignal, PCM-Signal, und ein Direct Stream Digital Signal, DSD-Signal, erfasst;
eine PCM-Upsampling-Einheit, welche die Abtastfrequenz des PCM-Signals auf eine Abtastfrequenz des DSD-Signals erhöht;
ein DSD-Filter, welches eine hochfrequente Komponente des DSD-Signals entfernt;
eine Verzögerungsbetrag-Detektionseinheit, welche eine Korrelation zwischen dem DSD-Signal, aus welchem eine hochfrequente Komponente entfernt worden ist, und dem PCM-Signal nach dem Upsampling analysiert und einen Verzögerungsbetrag detektiert; und
eine Überblendeinheit, welche das Timing des DSD-Signals und des PCM-Signals nach dem Upsampling unter Verwendung des detektierten Verzögerungsbetrages anpasst und das DSD-Signal und das PCM-Signal nach dem Upsampling überblendet.

**Revendications**

**1.** Appareil de traitement de signal (11) comprenant :

une unité d'acquisition (51) configurée pour acquérir un signal de modulation par impulsions et codage, PCM, et un signal numérique de flux direct, DSD ;

une unité de suréchantillonnage PCM (54) configurée pour suréchantillonner le signal PCM à une fréquence d'échantillonnage du signal DSD ;

un filtre DSD (71) configuré pour supprimer une composante haute fréquence du signal DSD ;

une unité de détection de quantité de retard (55) configurée pour analyser une corrélation entre le signal DSD dont une composante haute fréquence a été supprimée et le signal PCM après suréchantillonnage, et détecter une quantité de retard ; et

une unité de fondu enchaîné (58) configurée pour régler la synchronisation du signal DSD et du signal PCM après suréchantillonnage en utilisant la quantité de retard détectée et pour effectuer un fondu enchaîné du signal DSD et du signal PCM après suréchantillonnage.

2.  Appareil de traitement de signal (11) selon la revendication 1, comprenant en outre :

un filtre PCM (72) configuré pour supprimer une composante haute fréquence du signal PCM après suréchantillonnage, dans lequel

l'unité de détection de quantité de retard (55) est configurée pour analyser une corrélation entre le signal DSD dont une composante haute fréquence a été supprimée et le signal PCM après suréchantillonnage dont une composante haute fréquence a été supprimée, et pour détecter une quantité de retard.

3.  Appareil de traitement de signal (11) selon la revendication 1, comprenant en outre :

une unité de suréchantillonnage DSD (52) configurée, dans un cas où le signal DSD acquis par l'unité d'acquisition n'est pas un signal DSD présentant un débit binaire maximum pour lequel l'appareil de traitement de signal peut effectuer un traitement de signal, pour suréchantillonner le signal DSD acquis par l'unité d'acquisition en un signal DSD présentant le débit binaire maximum, dans lequel

l'unité de suréchantillonnage PCM (54) est configurée pour suréchantillonner le signal PCM à une fréquence d'échantillonnage du signal DSD après suréchantillonnage.

4.  Appareil de traitement de signal (11) selon la revendication 1, comprenant en outre :
une unité de modulation delta-sigma (59) configurée pour effectuer une modulation delta-sigma sur un signal de fondu enchaîné, qui est une sortie de l'unité de fondu enchaîné (58).

5.  Appareil de traitement de signal (11) selon la revendication 4, comprenant en outre :

une unité de détection de correspondance entre signaux (61) configurée pour détecter une correspondance entre le signal DSD fourni en entrée à l'unité de fondu enchaîné et le signal de fondu enchaîné modulé par l'unité de modulation delta-sigma ; et

une unité de commutation (62) configurée, dans un cas où une correspondance est détectée par l'unité de détection de correspondance entre signaux, pour faire basculer un signal fourni en entrée à un démodulateur delta-sigma (64) du signal de fondu enchaîné modulé par l'unité de modulation delta-sigma au signal DSD fourni en entrée à l'unité de fondu enchaîné.

6.  Appareil de traitement de signal (11) selon la revendication 1, comprenant en outre :

une unité de décodage (53) configurée pour décoder le signal PCM codé par compression selon un procédé de codage par compression prédéterminé, dans lequel

l'unité de suréchantillonnage PCM (54) est configurée pour suréchantillonner le signal PCM décodé par l'unité de décodage à une fréquence d'échantillonnage du signal DSD.

7.  Appareil de traitement de signal (11) selon la revendication 6, dans lequel l'unité de détection de quantité de retard (55) est configurée pour traiter une longueur de comparaison pour l'analyse d'une corrélation entre le signal DSD dont une composante haute fréquence a été supprimée et le signal PCM après suréchantillonnage, comme étant une longueur de trame du procédé de codage par compression, et pour analyser la corrélation.

8.  Procédé de traitement de signal comprenant les étapes, effectuées par un appareil de traitement de signal, consistant à :

acquérir un signal de modulation par impulsions et codage, PCM, et un signal numérique de flux direct, DSD ;

suréchantillonner le signal PCM à une fréquence d'échantillonnage du signal DSD ;

supprimer une composante haute fréquence du signal DSD ;

analyser une corrélation entre le signal DSD dont une composante haute fréquence a été supprimée et le signal PCM après suréchantillonnage, et détecter une quantité de retard ; et

régler la synchronisation du signal DSD et du signal PCM après suréchantillonnage en utilisant la quantité de retard détectée, et effectuer un fondu enchaîné du signal DSD et du signal PCM après suréchantillonnage.

9. Programme destiné à amener un ordinateur à fonctionner comme :

une unité d'acquisition qui acquiert un signal de modulation par impulsions et codage, PCM, et un signal numérique de flux direct, DSD ;

une unité de suréchantillonnage PCM qui suréchantillonne le signal PCM à une fréquence d'échantillonnage du signal DSD ;

un filtre DSD qui supprime une composante haute fréquence du signal DSD ;

une unité de détection de quantité de retard qui analyse une corrélation entre le signal DSD dont une composante haute fréquence a été supprimée et le signal PCM après suréchantillonnage, et qui détecte une quantité de retard ; et

une unité de fondu enchaîné qui règle la synchronisation du signal DSD et du signal PCM après suréchantillonnage en utilisant la quantité de retard détectée et qui effectue un fondu enchaîné du signal DSD et du signal PCM après suréchantillonnage.

FIG. 1

FIG. 2

# FIG. 3

| | | |
|---|---|---|
| 11.2M DSD DATA | 0010101001101010 | 0010101001101010 (NO CHANGE) |

UPSAMPLING PROCESSING →

| | | |
|---|---|---|
| 5.6M DSD DATA | 01101010 | 0011110011001100 (HOLD 1 PREVIOUS VALUE) |

| | | |
|---|---|---|
| 2.8M DSD DATA | 0110 | 0000111111110000 (HOLD 3 PREVIOUS VALUES) |

EP 3 618 312 B1

# FIG. 4

LF_DSD DATA $x_1$

20ms

LF_DSD DATA (1)

$\Rightarrow \sum_k x_1(k)\,x_2(k+\tau)$

LF_PCM DATA $x_2$

LF_DSD DATA $x_1$

20ms

LF_DSD DATA (2)

$\Rightarrow \sum_k x_1(k)\,x_2(k+\tau)$

LF_PCM DATA $x_2$

LF_DSD DATA $x_1$

LF_DSD DATA (N-m+1)

20ms

$\Rightarrow \sum_k x_1(k)\,x_2(k+\tau)$

LF_PCM DATA $x_2$

# FIG. 5

| 1-BIT SIGNALS OF 4 SAMPLES | FREQUENCY OF APPEARANCE OF 01 OF 4 SAMPLES | SIGNAL LEVEL OF 4 SAMPLES |
|---|---|---|
| 0000 | 4/0 | −4 |
| 0001 | 3/1 | −2 |
| 0010 | 3/1 | −2 |
| 0011 | 2/2 | 0 |
| 0100 | 3/1 | −2 |
| 0101 | 2/2 | 0 |
| 0110 | 2/2 | 0 |
| 0111 | 1/3 | +2 |
| 1000 | 3/1 | −2 |
| 1001 | 2/2 | 0 |
| 1010 | 2/2 | 0 |
| 1011 | 1/3 | +2 |
| 1100 | 2/2 | 0 |
| 1101 | 1/3 | +2 |
| 1110 | 1/3 | +2 |
| 1111 | 0/4 | +4 |

## FIG. 6

PREDETERMINED NUMBER OF SAMPLES (TIME)

| ORIGINAL DSD DATA SA | 0001 | 0010 | 0100 | 1010 | 0011 | 0110 | 1100 | 1001 |
|---|---|---|---|---|---|---|---|---|

MATCHING DETECTION SIGNAL ST

| ST |
|---|

| PCM CONVERTED DSD DATA SB | 0010 | 0110 | 0101 | 1010 | 1001 | 0101 | 1010 | 0110 |
|---|---|---|---|---|---|---|---|---|

## FIG. 7

| ORIGINAL DSD DATA SA | 0001 | 0110 | 0100 | 1010 | 0011 | 0110 | 1101 | 1100 |
|---|---|---|---|---|---|---|---|---|

MATCHING DETECTION SIGNAL ST

| PCM CONVERTED DSD DATA SB | 0101 | 0010 | 0010 | 0101 | 0101 | 1010 | 1100 | 1101 |
|---|---|---|---|---|---|---|---|---|

# FIG. 8

| ORIGINAL DSD DATA SA | 0001 | 0110 | 0100 | 1010 | 0011 | 0110 | 1101 | 1100 |
|---|---|---|---|---|---|---|---|---|
| (SIGNAL LEVEL OF ABOVE SA) | -2 | 0 | -2 | 0 | 0 | 0 | +2 | 0 |
| MATCHING DETECTION SIGNAL ST | | | ST | ST | ST | ST | | |
| (SIGNAL LEVEL OF BELOW SB) | 0 | -2 | -2 | 0 | 0 | 0 | 0 | +2 |
| PCM CONVERTED DSD DATA SB | 0101 | 0010 | 0010 | 0101 | 0101 | 1010 | 1100 | 1101 |

EP 3 618 312 B1

# FIG. 9

| ORIGINAL DSD DATA  SA | 0001 | 0110 | 0100 | 1010 | 0011 | 0110 | 1101 | 1100 |
|---|---|---|---|---|---|---|---|---|
| (SIGNAL LEVEL OF ABOVE SA) | −2 | 0 | −2 | 0 | 0 | 0 | +2 | 0 |
| MATCHING DETECTION SIGNAL  ST | | | | ST | ST | ST | | |
| (SIGNAL LEVEL OF BELOW SB) | 0 | −2 | −2 | 0 | 0 | 0 | 0 | +2 |
| PCM CONVERTED DSD DATA  SB | 0101 | 0010 | 0010 | 0101 | 0101 | 1010 | 1100 | 1101 |

EP 3 618 312 B1

## FIG. 10

| ORIGINAL DSD DATA SA | 0001 | 0110 | 0100 | 1010 | 0011 | 0110 | 1101 | 1100 |
|---|---|---|---|---|---|---|---|---|
| (FREQUENCY OF APPEARANCE OF 0/1 OF ABOVE SA) | 3/1 | 2/2 | 3/1 | 2/2 | 2/2 | 2/2 | 1/3 | 2/2 |
| MATCHING DETECTION SIGNAL ST | | | ST | ST | ST | ST | | |
| (FREQUENCY OF APPEARANCE OF 0/1 OF BELOW SB) | 2/2 | 3/1 | 3/1 | 2/2 | 2/2 | 2/2 | 2/2 | 1/3 |
| PCM CONVERTED DSD DATA SB | 0101 | 0010 | 0010 | 0101 | 0101 | 1010 | 1100 | 1101 |

EP 3 618 312 B1

## FIG. 11

| | | | | | | | | |
|---|---|---|---|---|---|---|---|---|
| ORIGINAL DSD DATA  SA | 0001 | 0110 | 0100 | 1010 | 0011 | 0110 | 1101 | 1100 |
| (FREQUENCY OF APPEARANCE OF 0/1 OF ABOVE SA) | 3/1 | 2/2 | 3/1 | 2/2 | 2/2 | 2/2 | 1/3 | 2/2 |
| MATCHING DETECTION SIGNAL  ST | | | | ST | ST | ST | | |
| (FREQUENCY OF APPEARANCE OF 0/1 OF BELOW SB) | 2/2 | 3/1 | 3/1 | 2/2 | 2/2 | 2/2 | 2/2 | 1/3 |
| PCM CONVERTED DSD DATA  SB | 0101 | 0010 | 0010 | 0101 | 0101 | 1010 | 1100 | 1101 |

# FIG. 12

```
┌─────────────────────────────────────────────┐
( DSD DATA REPRODUCTION PROCESSING STARTS )
└─────────────────────────────────────────────┘
                        │
                        ▼
┌─────────────────────────────────────────────┐  S1
│          DETERMINE DSD DATA HAVING           │
│ PREDETERMINED BIT RATE AS ACQUIRED AUDIO DATA│
└─────────────────────────────────────────────┘
                        │
                        ▼
┌─────────────────────────────────────────────┐  S2
│          RECEIVE DSD DATA TRANSMITTED        │
│              FROM SERVER APPARATUS           │
└─────────────────────────────────────────────┘
                        │
                        ▼
┌─────────────────────────────────────────────┐  S3
│          UPSAMPLE DSD DATA HAVING            │
│ PREDETERMINED BIT RATE TO DSD DATA OF 11.2Mbps│
└─────────────────────────────────────────────┘
                        │
                        ▼
┌─────────────────────────────────────────────┐  S4
│   DELTA-SIGMA DEMODULATE 11.2M DSD DATA      │
│        AND OUTPUT RESULTANT DATA             │
└─────────────────────────────────────────────┘
                        │
                        ▼
                   (   END   )
```

# FIG. 13

AAC DATA REPRODUCTION PROCESSING STARTS

DETERMINE AAC DATA AS ACQUIRED AUDIO DATA | S21

RECEIVE AAC DATA TRANSMITTED
FROM SERVER APPARATUS | S22

DECODE AAC DATA AND UPSAMPLE
PCM SIGNAL OBTAINED BY DECODING TO PCM SIGNAL
HAVING SAMPLING FREQUENCY OF 11. 2MHz | S23

DELTA-SIGMA MODULATE PCM SIGNAL
HAVING SAMPLING FREQUENCY
OF 11.2MHz AND GENERATE 11.2M DSD DATA | S24

DELTA-SIGMA DEMODULATE 11.2M DSD DATA
AND OUTPUT RESULTANT DATA | S25

END

# FIG. 14

```
( REPRODUCTION SWITCH PROCESSING STARTS )
                     │
                     ▼
┌─────────────────────────────────────────────────────────┐
│  DETERMINE 2.8M DSD DATA AS ACQUIRED AUDIO DATA          │ S41
│  IN ADDITION TO AAC DATA                                 │
└─────────────────────────────────────────────────────────┘
                     │
                     ▼
┌─────────────────────────────────────────────────────────┐
│  RECEIVE AAC DATA AND 2.8M DSD DATA TRANSMITTED          │ S42
│  FROM SERVER APPARATUS                                   │
└─────────────────────────────────────────────────────────┘
                     │
                     ▼
┌─────────────────────────────────────────────────────────┐
│  UPSAMPLE 2.8M DSD DATA TO 11.2M DSD DATA                │ S43
└─────────────────────────────────────────────────────────┘
                     │
                     ▼
┌─────────────────────────────────────────────────────────┐
│  DECODE AAC DATA AND UPSAMPLE PCM SIGNAL OBTAINED BY DECODING │ S44
│  TO PCM SIGNAL HAVING SAMPLING FREQUENCY OF 11.2MHz      │
└─────────────────────────────────────────────────────────┘
                     │
                     ▼
┌─────────────────────────────────────────────────────────┐
│  REMOVE HIGH-FREQUENCY COMPONENT OF FED DATA             │ S45
│  AND STORE RESULTANT DATA IN BUFFER                      │
└─────────────────────────────────────────────────────────┘
                     │
                     ▼
┌─────────────────────────────────────────────────────────┐
│  ANALYZE CORRELATION BETWEEN LF_DSD DATA AND LF_PCM DATA STORED IN BUFFER, │ S46
│  AND DETECT DELAY AMOUNT N3 OF LF_PCM DATA AND LF_PCM DATA │
└─────────────────────────────────────────────────────────┘
                     │
                     ▼
┌─────────────────────────────────────────────────────────┐
│  DETECT DELAY AMOUNT D BETWEEN SIGNALS FROM TIME DIFFERENCE │ S47
│  OF FILTERING PROCESSING AND DELAY AMOUNT N3             │
└─────────────────────────────────────────────────────────┘
                     │
                     ▼
┌─────────────────────────────────────────────────────────┐
│  DELAY 11.2M DSD DATA AND 11.2M PCM DATA PREDETERMINED AMOUNT │ S48
└─────────────────────────────────────────────────────────┘
                     │
                     ▼
┌─────────────────────────────────────────────────────────┐
│  PERFORM CROSSFADE PROCESSING ON 11.2M DSD DATA AND 11.2M PCM DATA │ S49
└─────────────────────────────────────────────────────────┘
                     │
                     ▼
┌─────────────────────────────────────────────────────────┐
│  DELTA-SIGMA MODULATE CROSSFADE SIGNAL                   │ S50
│  AFTER CROSSFADE PROCESSING TO GENERATE 11.2M DSD DATA   │
└─────────────────────────────────────────────────────────┘
                     │◄──────────────────────────┐
                     ▼                           │
          < HAS MATCHING BETWEEN ORIGINAL DSD DATA     > S51
          < AND PCM CONVERTED DSD DATA BEEN DETECTED?  > NO ─┘
                     │ YES
                     ▼
┌─────────────────────────────────────────────────────────┐
│  OUTPUT MATCHING DETECTION SIGNAL INDICATIVE OF DATA MATCHING TO SWITCH UNIT │ S52
└─────────────────────────────────────────────────────────┘
                     │
                     ▼
┌─────────────────────────────────────────────────────────┐
│  SWITCH INPUT OF AUDIO DATA TO BE OUTPUT                 │ S53
│  TO SUBSEQUENT DELTA-SIGMA DEMODULATOR                   │
└─────────────────────────────────────────────────────────┘
                     │
                     ▼
┌─────────────────────────────────────────────────────────┐
│  DELTA-SIGMA DEMODULATE 11.2M DSD DATA AND OUTPUT RESULTANT DATA │ S54
└─────────────────────────────────────────────────────────┘
                     │
                     ▼
                 ( END )
```

*FIG. 15*

11

- 64 ΔΣ DEMODULATOR (DAC)
- CKL2
- 63 CLOCK SUPPLY UNIT
- 61 SIGNAL MATCHING DETECTION UNIT
- 62
- 5.6M DSD
- 59 ΔΣ MODULATION UNIT
- 5.6M DSD
- 60 DELAY UNIT
- 58 CROSSFADE UNIT
- 57 DELAY UNIT
- 56 DELAY UNIT
- 50 CONTROL UNIT
- 5.6M DSD
- 5.6M PCM
- 55 DELAY AMOUNT DETECTION UNIT
- 71 LPF
- LF_DSD
- 73 DSD BUFFER
- x1
- 75 CORRELATION ANALYSIS UNIT
- N3
- 76 DELAY CONTROL UNIT
- D
- 74 PCM BUFFER
- x2
- 72 LPF
- LF_PCM
- 52 DSD UPSAMPLING UNIT
- 54 PCM UPSAMPLING UNIT
- 53 DECODE UNIT
- 51 COMMUNICATION UNIT
- 5.6M DSD DATA
- 2.8M DSD DATA
- AAC (PCM) DATA

36

# FIG. 16

EP 3 618 312 B1

FIG. 17

EP 3 618 312 B1

# FIG. 18

EP 3 618 312 B1

**EP 3 618 312 B1**

**Patent documents cited in the description**

- WO 2016140071 A
- WO 2016199596 A
- US 2009287493 A1
- US 2006058901 A1
- US 2015107442 A1